# EUROPÄISCHE PATENTSCHRIFT

(11) **EP 0 535 019 B1**
(45) Veröffentlichungstag und Bekanntmachung des Hinweises auf die Patenterteilung: **18.10.1995**
(21) Anmeldenummer: 91910493.5
(22) Anmeldetag: 08.06.1991
(51) Int. Cl.: C23C 14/28, C23C 14/56

(54) **VERFAHREN UND VORRICHTUNG ZUM BESCHICHTEN VON SUBSTRATMATERIAL**
PROCESS AND DEVICE FOR COATING SUBSTRATE MATERIAL
PROCEDE ET DISPOSITIF D'ENDUCTION DE SUBSTRATS

(30) Priorität: 21.06.1990 DE 4019824; 22.06.1990 DE 4019965
(43) Veröffentlichungstag der Anmeldung: 07.04.1993
(73) Patentinhaber: Deutsche Forschungsanstalt für Luft- und Raumfahrt e.V., 51126 Köln (DE); VOEST-ALPINE STAHL LINZ GmbH, A-4020 Linz (AT)
(72) Erfinder: OPOWER, Hans, D-8033 Krailling (DE); KÖSTERS, Kurt, A-4040 Puchenau (AT); EBNER, Reinhold, A-8793 Trofaiach (AT)
(74) Vertreter: Hoeger, Stellrecht & Partner
(86) Internationale Anmeldenummer: EP9101075
(87) Internationale Veröffentlichungsnummer: WO9119827

(56) Entgegenhaltungen:
- EP-A- 0 305 573
- EP-A- 0 337 369
- DD-A- 136 047
- DE-A- 3 527 259
- DE-A- 3 542 613
- DE-A- 3 615 487
- US-A- 3 205 086
- PATENT ABSTRACTS OF JAPAN, Band 13, Nr. 549 (C-662)(3897), 07. Dezember 1989
- PATENT ABSTRACTS OF JAPAN, Band 13, Nr. 487 (C-649)(3835), 06. November 1989
- GALVANOTECHNIK, Band 80, Nr. 11, 1989; Seiten 3790-3798
- STAHL UND EISEN, Band 111, Nr. 11, 1991; Seiten 77-84

## Beschreibung

Die Erfindung betrifft ein Verfahren und eine Vorrichtung zum Beschichten von Flachzeug als Substratmaterial, bei welchem das Flachzeug als Endlosband durch eine Unterdruck aufweisende Beschichtungskammer kontinuierlich unter Aufrechterhaltung des für die Beschichtung erforderlichen Unterdrucks hindurchgeführt wird und bei welchem in der Unterdruck aufweisenden Beschichtungskammer Beschichtungsmaterial in einem Ablationsbereich von einem Laserstrahl ablatiert wird, sich in Form eines Beschichtungsteilchenstroms in Richtung des Flachzeugs ausbreitet und auf diesem in Form einer Beschichtung abgeschieden wird.

Derartige Verfahren sind aus dem Stand der Technik bekannt (vgl. z.B. Patent Abstracts of Japan, Bd. 13, Nr. 487 (C-649) [3835], 06.11.1989 & JP-A-1-191 744). Allerdings wird bei all diesen Verfahren das zu beschichtende Substratmaterial in die Beschichtungskammer eingebracht, die Beschichtungskammer auf Unterdruck gefahren und dann das Beschichtungsmaterial mit einem Laserstrahl ablatiert.

Ein derartiges Verfahren ist für die Herstellung großer Mengen von laserbeschichtetem Substratmaterial nicht rationell und daher nicht anwendbar.

Der Erfindung liegt daher die Aufgabe zugrunde, sowohl ein Verfahren als auch eine Vorrichtung zu schaffen bei welchem Substratmaterial in großen Mengen durch Laserablation möglichst gleichmäßig und dauerhaft beschichtet werden kann.

Diese Aufgabe wird bei einem Verfahren und einer Vorrichtung der eingangs beschriebenen Art erfindungsgemäß dadurch gelöst, daß der Beschichtungskammer das erforderliche Beschichtungsmaterial unter Aufrechterhaltung des für die Beschichtung erforderlichen Unterdrucks zugeführt wird, daß die Ablation durch den Laserstrahl in dem Ablationsbereich mit einer Leistungsdichte von mindestens 10⁵ W/cm² so erfolgt, daß ein exakt gerichteter Beschichtungsteilchenstrahl erzeugt und mit diesem beschichtet wird, daß mehrere in einer Querrichtung zur Durchzugsrichtung im Abstand voneinander angeordnete Ablationsbereiche vorgesehen werden und daß in diesen Ablationsbereichen jeweils mit dem Laserstrahl ablatiert wird.

Der Vorteil des erfindungsgemäßen Verfahrens ist somit darin zu sehen, daß durch Verkettung einzelner Stücke von Substratmaterial zu einem Endlosband die Möglichkeit geschaffen wurde, dieses Endlosband kontinuierlich, das heißt mit konstanter Geschwindigkeit oder in bestimmten Vorschubzyklen, durch die Beschichtungskammer hindurchzuführen, dabei den Unterdruck in der Beschichtungskammer aufrecht zu erhalten und bei diesem kontinuierlichen Hindurchführen des Endlosbandes ständig die Beschichtung durchzuführen, so daß vorzugsweise eine konstante Beschichtung auf dem Substratmaterial, im erfindungsgemäßen Fall dem Endlosband, entsteht.

Ferner wird durch das erfindungsgemäße Vorsehen mehrerer in Querrichtung nebeneinander angeordneter Ablationsbereiche in der Querrichtung, das heißt also über die Breite des Flachzeugs oder Endlosbandes, die möglichst gleichmäßige Beschichtung erreicht.

Da bei der großtechnischen Anwendung die Forderung besteht, durch das ständig durch die Beschichtungskammer laufende Endlosband auch große Mengen von Beschichtungsmaterial in die Beschichtungskammer einzuführen, ist es vorteilhaft, wenn das Beschichtungsmaterial ohne Unterbrechung des Durchzugs des Endlosbandes zugeführt wird.

Darüberhinaus ist es günstig, wenn das Beschichtungsmaterial ohne Unterbrechung der Beschichtung auf dem Endlosband zugeführt wird.

Das Problem bei einer großtechnischen Beschichtung des Endlosbandes ist auch darin zu sehen, daß die Beschichtung möglichst gleichmäßig und dauerhaft auf dem Endlosband haftet auftrifft und insbesondere eine im wesentlichen gleichmäßige Dicke aufweist.

Daher sieht ein besonders bevorzugtes Ausführungsbeispiel des erfindungsgemäßen Verfahrens und der dabei verwendeten Vorrichtung vor, daß zum Auftragen einer gleichmäßigen Beschichtung auf dem Flachzeug der Beschichtungsteilchenstrom relativ zum Flachzeug mit einer Komponente in Querrichtung zur Durchzugsrichtung des Endlosbandes bewegt wird.

Diese Bewegung kann einerseits dadurch erfolgen, daß der Beschichtungsteilchenstrom mit einer Komponente in der Querrichtung oszillierend verschwenkt wird.

Andererseits ist es aber auch günstig, wenn der Beschichtungsteilchenstrom mit einer Komponente in der Querrichtung parallel verschoben wird. Um die Dicke der Beschichtung konstant zu halten, ist es weiterhin besonders vorteilhaft, wenn bei der Bewegung des Beschichtungsteilchenstroms mit einer Komponente in der Querrichtung ein Abstand zwischen dem Ablationsbereich und dem Flachzeug, insbesondere dem Bereich des Flachzeugs, auf welchem der Beschichtungsteilchenstrom auftrifft, im wesentlichen konstant gehalten wird.

Zur Verschiebung des Beschichtungsteilchenstroms mit einer Komponente in der Querrichtung relativ zum Flachzeug sind mehrere erfindungsgemäße Lösungen vorgesehen. So ist beispielsweise bei einer günstigen Lösung vorgesehen, daß zur Verschiebung des Beschichtungsteilchenstroms mit einer Komponente in der Querrichtung der Ablationsbereich mit einer Komponente in der Querrichtung verschoben wird.

Insbesondere zweckmäßig ist es dabei, wenn der Abstand der Ablationsbereiche in der Querrichtung so gewählt wird, daß sich die von den einzelnen Ablationsbereichen ausgehenden Beschichtungsteilchenströme im wesentlichen nicht überlagern. In diesem Fall muß allerdings dafür Sorge getragen werden, daß unterschiedliche Beschichtungsteilchenstromdichten in den Beschichtungsteilchenströmen ausgeglichen werden.

Alternativ dazu ist es daher im Rahmen der vorliegenden Erfindung noch vorteilhafter, wenn der Abstand der Ablationsbereiche so gewählt wird, daß sich die von diesen ausgehenden Beschichtungsteilchenströme überlagern. Durch diese Überlagerung besteht zumindest in gewissen Bereichen die Möglichkeit, einen Ausgleich für unterschiedliche Beschichtungsteilchenstromdichten zu schaffen.

Daher sieht ein besonders bevorzugtes Ausführungsbeispiel vor, daß der Abstand so gewählt wird, daß die einander überlagernden Beschichtungsteilchenströme einen Gesamtbeschichtungsteilchenstrom mit einer im wesentlichen konstanten Beschichtungsteilchenstromdichte bilden.

Bei den nun in der Querrichtung im Abstand voneinander vorgesehenen Ablationsbereichen kann nun auf unterschiedlichste Art und Weise eine Ablation durchgeführt werden. So sieht ein vorteilhaftes Ausführungsbeispiel vor, daß bei den in der Querrichtung im Abstand voneinander angeordneten Ablationsbereichen nacheinander mit einem einzigen Laserstrahl ablatiert wird, das heißt, daß eine Vorrichtung zur Ablenkung dieses einzigen Laserstrahls vorgesehen wird, welche diesen nacheinander auf die einzelnen Ablationsbereiche auftreffen läßt. Dies hat den Vorteil, daß mit einem einzigen Laser gearbeitet werden kann und daß sichergestellt ist, daß im wesentlichen mit der gleichen Energieleistung in jedem Ablationsbereich verdampft wird.

Allerdings hat die vorstehend bestehende Vorgehensweise und die entsprechende Vorrichtung den Nachteil, daß der Laser eine sehr große Leistung aufweisen muß, um die notwendige Laserleistung für die Gesamtablation zu haben.

Aus diesem Grund ist es vorteilhaft, wenn bei den in der Querrichtung im Abstand voneinander angeordneten Verdampfungsbereichen gleichzeitig mit jeweils einem Laserstrahl ablatiert wird. Dieser Laserstrahl kann beispielsweise von jeweils einem Laser kommen, so daß jeder Ablationsbereich durch den Laserstrahl eines diesem zugeordneten Lasers beaufschlagt wird. Es ist aber auch denkbar, mehrere Ablationsbereiche über einen Laser zu versorgen, wobei dann der Laserstrahl dieses einen Lasers durch entsprechende Strahloptiken in unterschiedliche Laserstrahlen, die zu den unterschiedlichen Ablationsbereichen führen, aufgeteilt wird. Damit kann beispielsweise die Vielzahl von Ablationsbereichen durch eine geringere Zahl von Lasern, denen einzelne Ablationsbereiche eindeutig zugeordnet sind, versorgt werden. Weiterhin ist es im Rahmen der vorliegenden Erfindung denkbar, einen Laserstrahl eines einzigen Lasers nacheinander auf mehrere diesem zugeordnete Ablationsbereiche zu richten, gleichzeitig aber mehrere Laser vorzusehen, mit deren Laserstrahlen das gleiche durchgeführt wird, so daß jeweils eine gewisse Teilmenge der Gesamtzahl von Ablationsbereichen von einem Laserstrahl nacheinander beaufschlagt wird.

Um weiterhin eine Vergleichmäßigung der Beschichtung, insbesondere der Dichte derselben, zu erreichen, ist es ferner günstig, wenn in Durchzugsrichtung des Endlosbandes mehrere Ablationsbereiche für das Beschichtungsmaterial aufeinanderfolgend angeordnet sind.

Vorzugsweise kann in diesen in Durchzugsrichtung aufeinanderfolgend angeordneten Ablationsbereichen dasselbe Beschichtungsmaterial verdampft werden, so daß ein größeres Schichtwachstum mit dieser Anordnung erreichbar ist und weiterhin durch Versetzung der in Durchzugsrichtung aufeinanderfolgend angeordneten Ablationsbereiche in Querrichtung noch eine weitere Vergleichmäßigung der Beschichtung.

Darüberhinaus bietet die Anordnung mehrerer in Durchzugsrichtung des Endlosbandes aufeinanderfolgend angeordneter Ablationsbereiche auch die Möglichkeit, unterschiedliches Beschichtungsmaterial zu ablatieren und dadurch Beschichtungen aufzubauen, die unterschiedliche Lagen unterschiedlicher Beschichtungsmaterialien aufweisen, oder auch unterschiedliche Beschichtungsmaterialien mit unterschiedlichen Ablationsbedingungen zu ablatieren, jedoch dafür zu sorgen, daß sich die Beschichtungsteilchenströme miteinander vermischen und somit eine Mischbeschichtung erhältlich ist, wobei je nach Ablationsbedingungen bei den einzelnen Beschichtungsmaterialien die Mischungsverhältnisse dieser Mischbeschichtung geändert werden können.

Besonders günstig wäre es bei unterschiedlichen Beschichtungsmaterialien, wenn das Flachzeug von einem in der Querrichtung im wesentlichen eine konstante Beschichtungsteilchenstromdichte aufweisenden ersten Beschichtungsteilchenstrom und gleichzeitig und von einem in Durchzugsrichtung des Endlosbandes versetzt angeordneten, in der Querrichtung im wesentlichen eine konstante Beschichtungsteilchenstromdichte aufweisenden zweiten Beschichtungsteilchenstrom beschichtet wird.

Dadurch ließe sich beispielsweise dann, wenn erfindungsgemäß die Beschichtungsteilchenströme dasselbe Beschichtungsmaterial tragen, eine möglichst geringe Unterschiede in der Dicke aufweisende Beschichtung auftragen und dann, wenn die Beschichtungsteilchenströme unterschiedliches Beschichtungsmaterial tragen, eine gemischte oder schichtweise getrennte Beschichtungsmaterialien aufweisende Schicht mit zumindest in ihrer Gesamtheit im wesentlichen konstanter Dicke.

Bei den bislang beschriebenen Ausführungsbeispielen wurde nicht näher darauf eingegangen, wie das Beschichtungsmaterial in die Beschichtungskammer eingebracht und ablatiert werden soll. So sieht ein besonders bevorzugtes Ausführungsbeispiel vor, daß das Beschichtungsmaterial von einem Festkörper ablatiert wird.

Im einfachsten Fall ist dabei der Festkörper aus dem Beschichtungsmaterial hergestellt.

Es ist aber auch, insbesondere bei Mischbeschichtungen, vorgesehen, daß der Festkörper aus mehreren Beschichtungsmaterialien hergestellt ist, wobei die Laserablation den großen Vorteil bietet, daß die unterschiedlichen Beschichtungsmaterialien im wesentlichen in gleicher Weise ablatiert werden können.

Im einfachsten Fall, insbesondere bei Herstellung einer Mischbeschichtung, ist vorgesehen, daß der Festkörper aus einer im wesentlichen homogenen Mischung von Beschichtungsmaterialien hergestellt ist, die mit Laserstrahlung besonders einfach ablatiert und in Form einer möglichst homogenen Schicht auf dem Flachzeug aufgetragen werden können.

Es ist aber auch denkbar, daß der Festkörper mehrere Beschichtungsmaterialien in räumlich getrennter Anordnung aufweist, wobei beispielsweise der Wechsel der Beschichtungsmaterialien dadurch möglich ist, daß der Ablationsbereich auf dem Festkörper wandert.

Alternativ zur Ablation von Beschichtungsmaterial, ausgehend von einem Festkörper, ist es aber auch denkbar, daß das Beschichtungsmaterial von einer Schmelze ablatiert wird, wobei von einer Schmelze in besonders vorteilhafter Weise eine Nachführung des Beschichtungsmaterials in die Beschichtungskammer vorgenommen werden kann und beispielsweise durch einen konstant gehaltenen Oberflächenspiegel der Schmelze der Abstand zwischen dem Ablationsbereich und dem Flachzeug in einfacher Weise über lange Zeit und konstant aufrecht erhalten werden kann.

Bei all den Ausführungsbeispielen des erfindungsgemäßen Verfahrens und der erfindungsgemäßen Vorrichtung, bei welchen das Beschichtungsmaterial von einem Festkörper ablatiert wird, ist vorzugsweise vorgesehen, daß das Beschichtungsmaterial in Form eines Targets in die Beschichtungskammer eingeführt wird.

Um das Beschichtungsmaterial von dem Target nun möglichst vorteilhaft zu ablatieren, ist bei einem zweckmäßigen Ausführungsbeispiel vorgesehen, daß der Ablationsbereich an einem stirnseitigen Ende des Targets aus Beschichtungsmaterial angeordnet ist.

Alternativ dazu ist es aber auch in erfindungsgemäßer Weise vorteilhaft, wenn der Ablationsbereich an einem vorderen mantelseitigen Ende des Targets aus Beschichtungsmaterial angeordnet ist.

In allen Fällen besteht das Problem, das Beschichtungsmaterial vom Target möglichst gleichmäßig abzutragen. Aus diesem Grund sieht eine erfindungsgemäße vorteilhafte Lösung vor, daß der Ablationsbereich durch eine Relativbewegung zwischen dem Target und dem Laserstrahl auf dem Target wandert.

Besonders vorteilhaft ist die vorstehend genannte Lösung dann, wenn das Wandern des Ablationsbereichs zu einer gleichmäßigen Form des Targets in dessen ablatierten Bereichen führt, das heißt, daß das Target durch das Wandern des Ablationsbereichs ständig in einer bestimmten Form gehalten wird. Beispielsweise wäre es denkbar, den ablatierten Bereich des Targets als ebene Fläche auszubilden und durch Wandern des Ablationsbereichs die Form der Fläche aufrechtzuerhalten. Es ist aber auch denkbar, den ablatierten Bereich des Targets als Kegel oder Kugelkappe auszubilden und durch Wandern des Ablationsbereichs die Form dieses Kegels oder dieser Kugelkappe aufrechtzuerhalten.

Im einfachsten Fall sieht eine bevorzugte Lösung vor, daß die Relativbewegung zwischen Laserstrahl und Target durch ein Bewegen des Laserstrahls erfolgt. Dies ist deshalb zweckmäßig, da der Laserstrahl in einfacher Weise, beispielsweise durch Ablenkoptiken, bewegbar ist. Dadurch wird gleichzeitig erreicht, daß mit der Bewegung des Laserstrahls auch der ablatierte Beschichtungsteilchenstrom räumlich relativ zum Target wandert, was bei einem feststehenden Target und einem in Querrichtung verschieblichen Flachzeug zu einer Wanderung des Beschichtungsteilchenstroms relativ zum Flachzeug führt, womit unterschiedliche Beschichtungsteilchenstromdichten im Beschichtungsteilchenstrom erreichbar sind.

Alternativ dazu ist es aber auch vorteilhaft, wenn die Relativbewegung zwischen dem Laserstrahl und dem Target durch eine Bewegung des Targets erfolgt. Dies hat den Vorteil, daß bei feststehendem Laserstrahl auch der Beschichtungsteilchenstrom nicht wandert, was ebenfalls bei all den Ausführungsbeispielen, bei welchen ein feststehender Beschichtungsteilchenstrom erwünscht ist, zweckmäßig ist.

Eine besonders einfache Möglichkeit, das Beschichtungsmaterial in die Beschichtungskammer einzuführen, ist dann gegeben, wenn das Target als endloser Strang ausgebildet ist. Vorzugsweise ist dabei vorgesehen, daß der Strang einen runden Querschnitt aufweist.

Allerdings ist es alternativ dazu aber auch im Rahmen der erfindungsgemäßen Lösung denkbar, wenn der Strang als Band, vorzugsweise mit einem rechteckigen Querschnitt, ausgebildet ist.

Der Strang bietet den Vorteil einer leichten Einführung in die Beschichtungskammer nämlich dadurch, daß der Strang durch eine Dichtschleuse in die Beschichtungskammer eingeführt und ständig nachgeführt wird.

Alternativ zum Zuführen des Beschichtungsmaterials in Form eines Strangs sieht eine andere erfindungsgemäße Lösung vor, daß das Target durch voneinander getrennte Stücke aus Beschichtungsmaterial gebildet wird.

In diesem Fall ist es dann günstig, wenn das Beschichtungsmaterial in diesen Stücken in die Beschichtungskammer eingebracht wird.

Um den Unterdruck in der Beschichtungskammer aufrechtzuerhalten ist vorgesehen, daß die Stücke durch eine Schleuse in die Beschichtungskammer eingebracht werden.

Besonders vorteilhaft ist es, insbesondere um den Beschichtungsvorgang nicht zu unterbrechen, wenn während des Ablatierens des Beschichtungsmaterials von einem Stück ein weiteres Stück in die Beschichtungskammer eingebracht wird.

Bislang wurde zur Form der Stücke keine Aussage gemacht. Vorteilhaft ist es hierbei aber, wenn die Stücke die Form langgestreckter Zylinder aufweisen.

Darüberhinaus ist es, insbesondere um ein gleichmäßiges Abtragen des Beschichtungsmaterials von diesen Stücken zu erreichen, wenn die Zylinder um ihre Zylinderachse rotierend gelagert sind. Dadurch läßt sich in einfacher Weise eine Relativbewegung des Ablationsbereichs zum Target erreichen.

Eine bevorzugte Anordnung sieht vor, daß sich die Zylinderachse quer zur Bewegungsrichtung des Endlosbandes erstreckt.

Ferner ist es dabei vorteilhaft, wenn die Zylinderachse im wesentlichen parallel zur Oberfläche des Endlosbandes oder Flachzeugs ausgerichtet ist, da in diesem Fall beispielsweise in besonders einfacher Weise die Möglichkeit besteht, den Beschichtungsteilchenstrom durch eine Bewegung des Ablationsbereichs wandern zu lassen.

Besonders einfach läßt sich eine Zufuhr der Stücke dann erreichen, wenn die Stücke in einer Magazinkammer angeordnet sind, wobei vorzugsweise die Magazinkammer in die Beschichtungskammer mündet.Die Anordnung der Stücke, die nacheinander zur Ablation vorgesehen sind, kann in unterschiedlichster Art und Weise erfolgen. Besonders zweckmäßig ist es, wenn die Stücke in einem Wendemagazin angeordnet sind, welches die Möglichkeit schafft, die Stücke nacheinander in eine Targetposition zur Ablation zu bringen.

Um eine möglichst hohe Speicherdichte in dem Wendemagazin zu erreichen, ist vorgesehen, daß die Stücke in dem Wendemagazin parallel zueinander ausgerichtet sind.

Ferner sieht eine vorteilhafte Version der erfindungsgemäßen Lösung mit einem Wendemagazin vor, daß die Stücke in das Wendemagazin nachgeladen werden, so daß beispielsweise während der Ablation eines Stücks des Wendemagazins ein Nachladen eines anderen Stücks in das Wendemagazin erfolgen kann.

Besonders zweckmäßig ist eine erfindungsgemäße Lösung, bei welcher das Wendemagazin in einer Magazinkammer sitzt.

Besonders günstig ist, wenn mehrere Magazinkammern vorgesehen sind, so daß beispielsweise ein Stück einer Magazinkammer ablatiert werden kann, während die andere Magazinkammer von der Beschichtungskammer getrennt ist und in dieser ein Nachladen des Wendespeichers erfolgen kann.

Aus diesem Grund ist vorzugsweise beim Vorsehen mehrerer Magazinkammern eine Lösung so gewählt, daß mindestens von einem Stück einer Magazinkammer ablatiert wird, während insbesondere in den von der Beschichtungskammer vakuumdicht getrennten Magazinkammer ein Ersetzen von durch Ablation verbrauchten Stücken erfolgt. Bei Verwendung von Targets in Form von Stücken hat es sich als besonders zweckmäßig erwiesen, wenn sich die Stücke in Querrichtung zur Bewegungsrichtung des Endlosbandes erstrecken, wobei es besonders zweckmäßig ist, wenn sich die Stücke in der Richtung über das gesamte Endlosband erstrecken.

In diesem Fall ist es vorzugsweise möglich, die Stücke von mehreren Laserstrahlen gleichzeitig zu beaufschlagen und somit mehrere Ablationsbereiche zu schaffen. Alternativ oder ergänzend dazu ist es aber auch möglich, eine Lösung vorzusehen, bei welcher durch eine Relativbewegung zwischen dem zu ablatierenden Stück und dem Laserstrahl der Ablationsbereich wandert, wobei im einfachsten Fall der Ablationsbereich über die gesamte Breite des Endlosbandes wandern kann.

Die Relativbewegung läßt sich im einfachsten Fall ebenfalls durch eine Bewegung des Laserstrahls relativ zum feststehenden Stück erreichen. Es ist aber auch denkbar, die Relativbewegung durch eine Bewegung des Stücks relativ zum feststehenden Laserstrahl durchzuführen.

In allen Fällen ist es besonders vorteilhaft, wenn die Wanderung des Ablationsbereichs zum gleichmäßigen Abtrag des Beschichtungsmaterials von dem Stück verwendet wird.

Bei allen vorstehend beschriebenen Ausführungsbeispielen wurde nicht näher darauf eingegangen, ob das Beschichtungsmaterial in der im Target vorliegenden Form zum Aufbau der Schicht herangezogen werden soll oder ob eine Veränderung dieses Beschichtungsmaterials noch erfolgt. So sieht ein bevorzugtes Ausführungsbeispiel, bei welchem insbesondere Beschichtungen aus Metallen auf ein Endlosband aufgetragen werden, vor, daß die Atome oder Moleküle des ablatierten Beschichtungsmaterials ohne chemisch im Beschichtungsteilchenstrom zu reagieren, die Beschichtung auf dem Flachzeug aufbauen.

Alternativ dazu, insbesondere beim Aufbau von keramischen Schichten, besteht jedoch auch die Möglichkeit, die Atome oder Moleküle des ablatierten Beschichtungsteilchenstrom mit einem diesen durchdringenden Reaktionsgas zu einer zumindest Teil der Beschichtung auf dem Flachzeug bildenden chemischen Verbindung reagieren zu lassen, wobei hierzu die Reaktionsgeschwindigkeit und Reaktionsfreudigkeit dieser Reaktion Berücksichtigung finden muß. So ist es beispielsweise bei speziellen keramischen Materialien nicht möglich, diese Reaktion durchzuführen, so daß auch diese als feste bereits bestehende Verbindungen ablatiert und ohne chemische Veränderung im Verbindungsteilchenstrom auf das Flachzeug aufgetragen werden.

Bei den vorstehend beschriebenen Ausführungsbeispielen wurde lediglich darauf eingegangen, daß durch Relativbewegung des Beschichtungsteilchenstroms zum Flachzeug eine Vergleichmäßigung der Beschichtung, insbesondere der Dicke desselben, erreichbar ist.

Eine weitere bevorzugte Ausführungsform sieht jedoch vor, daß auf den Beschichtungsteilchenstrom auf seinem Weg zwischen dem Ablationsbereich und dem Flachzeug zur Verringerung des Beschichtungsteilchenstromdichtegradienten in diesem Beschichtungsteilchenstrom zusätzlich eingewirkt wird. Eine besonders einfache Art der Einwirkung auf den Beschichtungsteilchenstrom ist dadurch gegeben, daß auf diesen mittels weiterer Teilchen eingewirkt wird.

Diese weiteren Teilchen können beliebiger Art sein. Besonders vorteilhaft ist es jedoch, wenn die weiteren Teilchen Gasteilchen sind.

Vorzugsweise lassen sich die weiteren Teilchen in Form eines auf den Beschichtungsteilchenstrom auftreffenden Teilchenstroms zuführen.

Im einfachsten Fall wird dies so gelöst, daß der zusätzliche Teilchenstrom den Beschichtungsteilchenstrom kreuzt.

Als Alternative oder ergänzend dazu ist es aber auch denkbar, daß die weiteren Teilchen in Form einer im wesentlichen mit dem Flachzeug mitbewegten Teilchenwolke zugeführt werden.

Eine Vergleichmäßigung der Beschichtungsteilchenstromdichte erhält man vorzugsweise dadurch, daß der Beschichtungsteilchenstrom mit den weiteren Teilchen durch Stöße wechselwirkt.

Zweckmäßigerweise ist dabei vorgesehen, daß der Beschichtungsteilchenstrom auf seinem Weg von dem Ablationsbereich zum Flachzeug im Mittel mindestens ungefähr einen Stoß mit den weiteren Teilchen durchführt. Vorzugsweise wird daher der Druck, unter dem die weiteren Teilchen stehen, entsprechend gewählt, so daß die freien Wege für die Beschichtungsteilchen in der Größenordnung des Abstandes zwischen dem Ablationsbereich und dem Flachzeug liegen.
Wenn ein höherer Wechselwirkungsgrad gewünscht wird, ist erfindungsgemäß die Möglichkeit gegeben, durch Erhöhung des Drucks bis zu im Mittel ungefähr zehn Stößen mit den weiteren Teilchen zu gehen.

Um zusätzlich insbesondere eine verstärkte Vergleichmäßigung in der Querrichtung zum Endlosband zu bewirken, ist vorgesehen, daß der weitere Teilchenstrom mit einer Komponente in Querrichtung zur Bewegungsrichtung des Endlosbandes bewegt wird und durch diese Bewegung den Beschichtungsteilchenstrom in der Querrichtung mitbewegt.

Zusätzlich kann dabei noch vorgesehen sein, daß der weitere Teilchenstrom eine Strömungskomponente in Durchzugsrichtung oder entgegengesetzt zur Durchzugsrichtung des Endlosbandes aufweist.

Im einfachsten Fall ist bei dem weiteren Teilchenstrom vorgesehen, daß es sich um einen Inertgasstrom handelt. In diesem Fall soll keine Reaktion zwischen den Beschichtungsteilchen des Beschichtungsteilchenstroms stattfinden.

Insbesondere dann, wenn jedoch eine Keramikbeschichtung auf das Endlosband aufgetragen werden soll, ist es auch denkbar, daß der weitere Teilchenstrom ein Reaktivgasstrom ist, so daß dieser Reaktivgasstrom einerseits zur Vergleichmäßigung des Beschichtungsteilchenstromsdichtegradienten beiträgt, andererseits aber durch den Reaktivgasstrom chemische Reaktionen mit den Beschichtungsteilchen erfolgen und sich chemische Verbindungen bilden, die dann zumindest Teil der auf das Endlosband aufwachsenden Beschichtung werden.

Im vorstehenden wurde lediglich darauf eingegangen, daß eine Vergleichmäßigung eines Beschichtungsteilchendichtestromgradienten erfolgen soll.

Mit zusätzlichen Teilchen besteht aber auch noch die Möglichkeit, daß durch die weiteren Teilchen eine Geschwindigkeitsmoderation der Beschichtungsteilchen im Beschichtungsteilchenstrom durchgeführt wird.

Besonders zweckmäßig ist es dabei, wenn durch die weiteren Teilchen eine zumindest teilweise Thermalisierung der Geschwindigkeit der Beschichtungsteilchen im Beschichtungsteilchenstrom durchgeführt wird. Dies hat den großen Vorteil, daß die sehr schnellen Teilchen im Beschichtungsteilchenstrom abgebremst werden und somit nicht mit allzu großer Geschwindigkeit auf das Flachzeug auftreffen und damit zu einer besseren und festeren Ausbildung der auf dem Flachzeug aufwachsenden Beschichtung beitragen, während zu schnelle Teilchen wieder Teilchen von der bereits aufgewachsenen Beschichtung oder dem Flachzeug lösen.

Eine weitere Möglichkeit der Einwirkung auf den Beschichtungsteilchenstrom ist die, daß auf den Beschichtungsteilchenstrom mittels einer Gasentladung eingewirkt wird.

Bevorzugterweise ist dabei vorgesehen, daß die Gasentladung eine Glimmentladung ist.

Zweckmäßigerweise wird diese Glimmentladung mittels weiterer Entladungsteilchen aufrecht erhalten, wobei vorzugsweise vorgesehen ist, daß die weiteren Entladungsteilchen mit dem Beschichtungsteilchenstrom wechselwirken

Die Wechselwirkung der weiteren Entladungsteilchen erfolgt dabei vorzugsweise durch Stöße mit dem Beschichtungsmaterialstrom.

Um insbesondere bei geringen Drucken arbeiten zu können, ist vorgesehen, daß die Glimmentladung durch ein Magnetfeld stabilisiert wird. Dieses Magnetfeld hat den Vorteil, daß die Elektronen im Kreis geführt werden und somit trotz der großen freien Weglänge der Elektronen eine nennenswerte Zahl von Stößen durch die Elektronen ausgeführt werden.

Weiter sieht eine bevorzugte Ausführungsform der Erfindung vor, daß die Glimmentladung durch Zufuhr von Entladungsteilchen stabilisiert wird. Beispielsweise wäre die Zufuhr von Entladungsteilchen die Zufuhr eines Gases.

Es ist aber auch bereits ausreichend, die Glimmentladung durch die Elektronen zu stabilisieren, die bei der Laserablation frei werden. Diese Elektronen sind beispielsweise dadurch nutzbar, daß man ein von dem Ablationsbereich als Kathode zu einer Anode verlaufendes Feld anlegt, wobei vorzugsweise eine oder mehrere Anoden seitlich des Beschichtungsteilchenstroms angeordnet werden.

Vorzugsweise wird auf den Beschichtungsteilchenstrom dergestalt eingewirkt, daß der Beschichtungsteilchenstrom quer zur Bewegungsrichtung der Entladungsteilchen in die Glimmentladung eintritt.

Ein anderes Ausführungsbeispiel sieht vor, daß der Beschichtungsteilchenstrom im wesentlichen in Bewegungsrichtung der Entladungsteilchen in die Glimmentladung eintritt und sich in der Glimmentladung fortsetzt.

Vorzugsweise erfolgt zunächst in der Glimmentladung eine Wechselwirkung in gleicher Weise wie bei einem normalen Gas, das heißt, es tritt durch eine Stoßwechselwirkung eine Geschwindigkeitsmoderation der Entladungsteilchen ein.

Zusätzlich führen die Stöße zwischen den Beschichtungsteilchen und den Elektronen zu einer weiteren Ionisation der Beschichtungsteilchen, welche dann in Form von Ionen auch den Einwirkungen des elektrischen Feldes in der Glimmentladung unterliegen. Diese zusätzliche Ionisation der Beschichtungsteilchen bringt den weiteren Vorteil, daß alle Ionen, die sich in Richtung auf das Flachzeug bewegen, in dem Kathodenfall unmittelbar vor der Kathode im wesentlichen entsprechend der im Kathodenfall abfallenden Spannung beschleunigt werden und somit die Gesamtzahl der Ionen eine im wesentlichen konstante Geschwindigkeit aufweist, mit der diese auf die aufwachsende Beschichtung auftreffen.

Die Ionen erhalten dabei in dem Kathodenfall eine Energie von einigen 100 eV, welche wesentlich höher ist als die Energie der ablatierten Neutralteilchen und das Schichtwachstum und die Schichthafteigenschaften verbessert, da in dem sich bildenden Plasma eine größere Energie für die Teilchen zur Verfügung steht, um die gewünschte räumliche Anordnung dieser Teilchen in der Beschichtung zu erreichen.

Eine weitere Möglichkeit der Einwirkung auf den Beschichtungsteilchenstrom besteht darin, daß auf den Beschichtungsteilchenstrom mittels Strahlung eingewirkt wird.

Ein Ausführungsbeispiel einer Strahlungseinwirkung wäre die Einwirkung mittels elektromagnetischer Strahlung auf den Beschichtungsteilchenstrom, eine andere Alternative oder Ergänzung wäre die Einwirkung auf den Beschichtungsteilchenstrom mittels Elektronenstrahlung.

Bei den Einwirkungsmöglichkeiten auf den Beschichtungsteilchenstrom steht zunächst eine Einwirkung auf den Beschichtungsteilchenstrom derart im Vordergrund, daß eine Verringerung des Beschichtungsteilchendichtestromgradienten selektiv mittels Strahlung eingewirkt wird.

Beispielsweise wäre dabei an eine selektive Aufheizung des Beschichtungsteilchenstroms zum Ausgleich des Beschichtungsteilchendichtegradienten zu denken.

Eine weitere Alternative ist die, daß auf den Beschichtungsteilchenstrom mittels eines Ionenstroms eingewirkt wird, wobei der Ionenstrom durch Führung in einem elektrischen oder magnetischen Feld in einer definierten Richtung gehalten werden kann.

Neben der Einwirkung auf den Beschichtungsteilchenstrom zum Ausgleich der Beschichtungsteilchenstromdichte ist es ebenfalls vorteilhaft, wenn auf den Beschichtungsteilchenstrom auf seinem Weg zwischen dem Ablationsbereich und dem Flachzeug zur Verringerung von Energieunterschieden zwischen den Beschichtungsteilchen zusätzlich eingewirkt wird.

Vorteilhaft ist es dabei, wenn die Einwirkung auf den Beschichtungsteilchenstrom mittels eines Ionenstroms, vorzugsweise aus einer Glimmentladung, erfolgt. Vorteilhafte Möglichkeiten einer Anordnung und Stabilisierung der Glimmentladung sowie die mit der Glimmentladung erzielbaren Effekte wurden bereits vorstehend erläutert. Eine andere Möglichkeit ist eine Einwirkung auf den Beschichtungsteilchenstrom mittels Strahlung, wobei vorzugsweise elektromagnetische Strahlung oder Elektronenstrahlung in Frage kommt.

Des weiteren ist es im Rahmen der erfindungsgemäßen Lösung vorteilhaft, wenn auf die Beschichtung während dieses Wachstums auf dem Flachzeug zur Verbesserung der Beschichtungseigenschaften, vorzugsweise zur Haftung und Dichte der Beschichtung, mittels energiereicher Teilchen eingewirkt wird.

Besonders zweckmäßig ist es hierbei, wenn mittels Ionenbeschuß auf die wachsende Beschichtung eingewirkt wird. Diese Ionen können beispielsweise aus einer Ionenkanone kommen. Eine andere Möglichkeit zum Ionenbeschuß der wachsenden Beschichtung besteht darin, daß die Ionen aus einer Gasentladung - insbesondere einer Glimmentladung - und/oder aus dem Beschichtungsteilchenstrom kommen und dabei im Kathodenfall der Gasentladung in Richtung der Beschichtung beschleunigt werden. Besonders vorteilhaft ist hierbei eine Nachionisation des Beschichtungsteilchenstroms, um dessen Ionengehalt zu steigern.

Eine dritte Möglichkeit ist, daß auf die Beschichtung mittels Elektronen eingewirkt wird.

Bei der erfindungsgemäßen Lösung sind alle Hochleistungslaser verwendbar, insbesondere Co₂-Laser, Nd YAG-Laser, Excimerlaser, Free Electron Laser oder auch Halbleiterlaser.

Je nach Leistungsdichte kann der Anteil an Tröpfchen, Clustern und Atomen im Beschichtungsteilchenstrom variiert werden.

Eine Möglichkeit der Verfahrensführung sieht daher vor, die Leistungsdichte des Laserstrahls im Ablationsbereich so zu wählen, daß der Beschichtungsteilchenstrom vorzugsweise Tröpfchen, Cluster und Atome umfaßt, wobei Leistungsdichten von größenordnungsmäßig 10⁵ bis 10⁸ W/cm² zweckmäßig sind.

Eine andere Möglichkeit der Verfahrensführung sieht daher vor, die Leistungsdichte des Laserstrahls im Ablationsbereich so zu wählen, daß der Beschichtungsteilchenstrom vorzugsweise angeregte Atome und Ionen umfaßt, wobei Leistungsdichten von größenordnungsmäßig größer 10⁸ W/cm² zweckmäßig sind.

Die verwendeten Laser werden bei einer Ausführungsform kontinuierlich betrieben.

Eine andere zweckmäßige Ausführungsform sieht jedoch gepulste Laser vor, günstigerweise mit Pulsdauern von weniger als 100 µs, noch günstiger von weniger als 1 µs.

Die Pulse sind bei einer zweckmäßigen Ausführungsform so gestaltet, daß die Ablation mit einem anfänglich eine große Leistungsdichte aufweisenden Teil des Pulses eingeleitet wird und nachfolgend mit geringerer Leistungsdichte eine Nachionisation der Beschichtungsteilchen im Beschichtungsteilchenstrom erfolgt.

Eine im Rahmen der Erfindung besonders vorteilhafte Verfahrensführung zum Beschichten sieht vor, das Flachzeug dann, wenn beispielsweise kristalline Schichten erzeugt werden sollen, erwärmt wird, was vor oder während des Beschichtungsvorgangs erfolgen kann, beispielsweise konduktiv, induktiv, über Infrorotstrahlung, mittels Glimmentladung, mittels Beschuß mit Laser-, Plasma-, Elektronen- oder Ionenstrahlen oder mittels heißer Gase.

Andererseits ist es dann, wenn beispielsweise amorphe Schichten erzeugt werden sollen, vorteilhaft, das Flachzeug zum Beschichten zu kühlen, was ebenfalls vor oder während der Beschichtung erfolgen kann.

Ferner ist bei dem erfindungsgemäßen Verfahren eine Erwärmung oder eine Kühlung des Targets von Vorteil, um hierdurch den Ablationsprozeß und die Art der Teilchen im Beschichtungsteilchenstrom zu beeinflussen.

Im Rahmen der bisherigen Darlegungen der Führung des erfindungsgemäßen Verfahrens und des Aufbaus der erfindungsgemäßen Vorrichtung wurde nicht näher darauf eingegangen, wie die Führung des Endlosbandes in der Beschichtungskammer erfolgen soll.

Aus Gründen der Stabilisierung des Drucks in der Beschichtungskammer ist vorgesehen, daß das Endlosband vor und nach der Beschichtungskammer durch eine Schleuse geführt ist.

Ferner ist vorzugsweise vorgesehen, daß das Endlosband in der Beschichtungskammer berührungslos geführt ist.

Ferner ist beim Vorsehen einer physikalischen Vorbehandlungseinheit vorzugsweise vorgesehen, daß zwischen der physikalischen Vorbehandlungseinheit und der Beschichtungskammer das Endlosband durch eine Schleuse berührungslos geführt ist.

Bei allen diesen Ausführungen zum erfindungsgemäßen Verfahren wurde lediglich im wesentlichen darauf eingegangen, wie die Beschichtung des Endlosbandes erfolgen soll. Es wurde nichts darüber gesagt, wie das gesamte Verfahren zu führen ist.

Besonders vorteilhaft im Rahmen der erfindungsgemäßen Lösung ist es daher, wenn das Endlosband durch eine mechanische Endlosbandbereitstellungseinheit hergestellt wird, wobei diese nacheinander Rollen von Bandmaterial abwickeln und das Ende der einen Rolle mit dem Schopf der anderen Rolle miteinander verbindet.

Ferner ist es zur Führung des erfindungsgemäßen Verfahrens vorteilhaft, wenn auf die mechanische Endlosbandbereitstellungseinheit folgend ein Bandspeicher angeordnet ist. Dieser Bandspeicher dient dazu, die Möglichkeit für eine konstante Durchzugsgeschwindigkeit bei dem erfindungsgemäßen Verfahren zu schaffen, während bei der Endlosbandbereitstellungseinheit durch das Verbinden jeweils zweier Rollen stets ein Abstoppen des Bandvorschubs erforderlich ist.

Ferner ist es vorteilhaft, wenn das Endlosband vor dem Beschichten mit Substratmaterial durch eine chemische Vorbehandlungseinheit geführt ist.

Zweckmäßig ist es dabei, wenn die chemische Vorbehandlungseinheit eine alkalische Entfettungseinheit umfaßt.

Ferner ist es vorteilhaft, wenn die alkalische Entfettungseinheit eine Spritzentfettung umfaßt.

Vorzugsweise umfaßt dabei die alkalische Entfettungseinheit eine elektrolytische Entfettung.

Darüberhinaus ist es zweckmäßig, wenn die elektrolytische Entfettung auf die Spritzentfettung folgend angeordnet ist.

Weiterhin ist es günstig, wenn die elektrolytische Entfettung von der Spritzentfettung durch eine Bürstenmaschine getrennt ist.

Zusätzlich ist es zweckmäßig, wenn zum Abschluß der alkalischen Entfettungseinheit eine Kaskadenspülung angeordnet ist.

Ein weiterer Vorteil ist dadurch gegeben, daß der Kaskadenspülung eine Bürstenmaschine vorgeschaltet ist.

Besonders vorteilhaft im Rahmen der erfindungsgemäßen Lösung ist es, wenn die chemische Vorbehandlungseinheit eine saure Dekapierung umfaßt.

Zweckmäßigerweise ist die saure Dekapierung auf die alkalische Entfettungseinheit folgend angeordnet.

Die saure Dekapierung ist insbesondere so ausgebildet, daß sie eine elektrolytische Zone umfaßt.

Ferner ist es günstig, wenn auf die elektrolytische Zone folgend eine Kaskadenspülung angeordnet ist.

Schließlich ist es zweckmäßig, wenn der Kaskadenspülung eine Bürstmaschine vorgeschaltet ist.

Darüberhinaus ist es vorteilhaft, wenn die chemische Vorbehandlungseinheit abschließend einen Trockner aufweist.

Neben einer chemischen Vorbehandlungseinheit ist es ferner günstig, wenn eine physikalische Vorbehandlungseinheit vorgesehen ist.

Zweckmäßigerweise ist die physikalische Vorbehandlungseinheit auf die chemische Vorbehandlungseinheit folgend angeordnet.

Zweckmäßig ist es dabei, wenn die physikalische Vorbehandlungseinheit eine Entgasungseinheit umfaßt, mit welcher sämtliche auf dem Endlosband adsorbierten Atome oder Moleküle entfernt werden können.

Die Entgasungseinheit ist zweckmäßigerweise so ausgebildet, daß in dieser zur Unterstützung der Desorption das Endlosband aufgeheizt und/oder Elektronenbeschuß und/oder Ionenbeschuß und/oder Plasmastrahlung und/oder Laserlicht und/oder UV-Licht ausgesetzt wird.

Insgesamt ist es für den Entgasungsvorgang fördernd, wenn die auf dem Endlosband adsorbierten Moleküle durch die vorstehend genannten Maßnahmen mit Energie versehen, insbesondere aufgeheizt werden, und somit die Desorption unterstützt wird.

Zweckmäßigerweise ist zur Aufrechterhaltung des Drucks in der Entgasungseinheit dieser eine Schleuse vor- und nachgeschaltet.Darüberhinaus ist es vorteilhaft, wenn die physikalische Vorbehandlungseinheit eine Vorwärmeinheit umfaßt.

Zweckmäßigerweise wird in der Vorwärmeinheit eine Aufheizung des Endlosbandes unter Schutzgasatmosphäre durchgeführt.

Besonders günstig ist es, wenn die physikalische Vorbehandlungseinheit eine physikalische Aktivierungseinheit umfaßt.

Diese physikalische Aktivierungseinheit ist vorzugsweise auf die Entgasungseinheit folgend angeordnet.

Ferner ist vorgesehen, daß zwischen der Entgasungseinheit und der physikalischen Aktivierungseinheit die Vorwärmeinheit angeordnet ist.

Hierbei ist es günstig, wenn der physikalischen Aktivierungseinheit eine Schleuse vorgeordnet ist.

Besonders zweckmäßig ist es, wenn in der physikalischen Aktivierungseinheit eine Aktivierung des Flachzeugs durch Elektronenbeschuß und/oder Ionenbeschuß und/oder Beschuß mit Plasmastrahlen und/oder Beschuß mit Laserlicht und/oder Beschuß mit UV-Licht erfolgt.

Besonders zweckmäßig ist es, wenn der Druck in der physikalischen Aktivierungseinheit größenordnungsmäßig gleich dem Druck in der Beschichtungskammer ist. Ein besonders bevorzugtes Ausführungsbeispiel sieht vor, daß der Ionenbeschuß in der physikalischen Aktivierungseinheit mittels einer Glimmentladung erfolgt.

Insbesondere um zu niedrigen Drucken gehen zu können, ist es dabei zweckmäßig, wenn die Glimmentladung durch ein Magnetfeld stabilisiert und unterstützt ist.

Zusätzlich ist eine weitere Unterstützung der Glimmentladung dadurch erreichbar, daß diese durch thermisch emittierte Elektronen in einem Hilfsstromkreis unterstützt wird, wobei hierzu beispielsweise seitlich des Beschichtungsteilchenstroms Anoden anzuordnen wären.

Die Drucke, bei welchen die Glimmentladung erfolgt, sind vorzugsweise so gewählt, daß sie zwischen 10³ und 10⁵ Pa (1o⁻² und 10⁻³ bar) liegen.

Eine besondere Ausführungsform der erfindungsgemäßen Lösung sieht vor, daß die Glimmentladung durch jochförmige Anoden erzeugt wird.

Vorzugsweise sind in den jochförmigen Anoden noch Spulen zur Erzeugung des Magnetfeldes angeordnet.

In einer besonders günstigen Konfiguration sind die jochförmigen Anoden topfförmig ausgebildet, wobei sie vorzugsweise mit ihrer offenen Seite dem Endlosband zugewandt angeordnet sind.

Hinsichtlich des Materials ist es vorteilhaft, wenn die jochförmigen Anoden aus einem magnetisierbaren Material sind, so daß der Fluß des Magnetfeldes teilweise durch die jochförmigen Anoden verlaufen kann und die jochförmigen Anoden insbesondere als Abschirmung für das Magnetfeld dienen.

Um die physikalische Aktivierung zu verbessern, ist vorzugsweise vorgesehen, daß die physikalische Aktivierungseinheit mehrere Aktivierungskammern umfaßt.

Zweckmäßigerweise sind die Aktivierungskammern dabei gegeneinander abgeschirmt.

Bei einem besonders bevorzugten Verfahren der erfindungsgemäßen Lösung ist vorgesehen, daß das Flachzeug in vertikaler Richtung durch die Beschichtungskammer geführt wird. Dies hat den Vorteil, daß sämtliche schweren Teilchen, beispielsweise Cluster, aus dem Beschichtungsteilchenstrom herausfallen und nicht auf die aufwachsende Beschichtung treffen. Ferner besteht auch die Gefahr, daß bei der Ablation größere Teilchen, die nicht in dem Beschichtungsteilchenstrom in Richtung auf das Endlosband wandern, herausgelöst werden, welche bei einer vertikalen Führung des Flachzeugs sich nicht in der Beschichtung niederschlagen.

Zur Aufrechterhaltung des Drucks in der Beschichtungskammer ist vorteilhafterweise vorgesehen, daß das Flachzeug vor der Beschichtungskammer und hinter der Beschichtungskammer durch eine Druckschleuse geführt wird.

Alternativ zu der vorstehend beschriebenen Lösung, bei welcher die physikalische Vorbehandlung, insbesondere die physikalische Aktivierung getrennt von dem Beschichtungsvorgang und somit auch getrennt von der Beschichtungskammer erfolgt, ist bei einer weiteren, insbesondere konstruktiv einfacheren Lösung vorgesehen, daß die physikalische Vorbehandlung vor dem Beschichtungsvorgang in einer von der Beschichtungskammer nicht getrennten Vorbehandlungskammer erfolgt.

Nach Beendigung der Beschichtung ist bei einer bevorzugten erfindungsgemäßen Verfahrensführung vorgesehen, daß eine physikalische Nachbehandlung der Beschichtung, insbesondere ein Halten des beschichteten Endlosbandes auf einer günstigen Temperatur erfolgt.

Die physikalische Nachbehandlung kann beispielsweise dazu dienen, thermische Reaktionen mit dem Grundwerkstoff erfolgen zu lassen.

Ferner ist es vorteilhaft, die physikalische Nachbehandlung auch noch durch eine chemische Nachbehandlung gleichzeitig oder danach zu ergänzen.

Beispielsweise ist eine Reaktivgasatmosphäre, insbesondere unterstützt durch eine Glimmentladung, zweckmäßig, um noch mit der Beschichtung eine Reaktion erfolgen zu lassen.

Vorteilhafte chemische Nachbehandlungen sind aber auch chemische Reaktionen mit der Beschichtung, wie Aufkohlung oder Aufstickung.

Nach der physikalischen Nachbehandlung ist ferner zweckmäßigerweise noch eine Kühlung des beschichteten Endlosbandes vorgesehen, wobei vor der Kühlung noch eine Messung der Schichteigenschaften, beispielsweise eine Schichtdickenmessung durch einen quer über das beschichtete Endlosband bewegbaren Meßkopf erfolgen kann.

Aufgrund der hohen Energiedichte des Laserstrahls ist grundsätzlich jedes Element verdampfbar und damit für eine Beschichtung mit dem erfindungsgemäßen Verfahren und der erfindungsgemäßen Vorrichtung potentiell geeignet. Ebenso sind alle Kombinationen von Elementen denkbar, womit die Palette der Beschichtungsstoffe nahezu unbegrenzt ist. Außerdem ist bei der erfindungsgemäßen Beschichtung ein nahezu unbegrenztes Potential hinsichtlich des Beschichtungsaufbaus und der Beschichtungsmöglichkeiten gegeben. Beispielsweise sind sowohl elektrisch leitende als auch nichtleitende Beschichtungsmaterialien einsetzbar, wie Reinmetalle, Legierungen, keramische Schichten, wie Oxide, Karbide, Nitride, Boride, Carbonitride, Silikate und ähnliche Stoffe einsetzbar.

Besonders vorteilhaft im Rahmen der erfindungsgemäßen Lösung ist es, Doppel- und Mehrfachschichten aufzubauen.

Erfindungsgemäß ist es auch möglich, durch Steuerung der Mischungsverhältnisse mehrerer Beschichtungsmaterialien Schichten mit Konzentrationsgradienten zu erzeugen.

Ein besonderer Vorteil der erfindungsgemäßen Lösung ist auch die Herstellung unterschiedlicher Schichten auf unterschiedlichen Seiten des Flachzeugs, wobei Art, Aufbau und Aufgabe der Schichten unterschiedlich gewählt werden können.

Weiterhin ist es bei der vorliegenden Erfindung besonders vorteilhaft, selektive Beschichtungen in der Querrichtung, d. h. der Breite des Endlosbandes sowie auch in Durchzugsrichtung durchzuführen, wobei hierzu beispielsweise entweder exakt gerichtete Beschichtungsteilchenstrahlen oder entsprechend ausgebildete Masken einsetzbar sind.

Ferner ist bei der erfindungsgemäßen Lösung ein großer Vorteil darin zu sehen, daß sich - sofern beispielsweise aus Kostengründen erwünscht - einseitige Beschichtungen sehr einfach durchführen lassen.

Das Haupteinsatzgebiet der heute denkbaren Beschichtungen von Metallen und Legierungen ist der Korrosionsschutz. Einsatzbereiche sind vorwiegend die Automobil-, Hausgeräte- und Bauindustrie. Für die Verarbeitung wesentlich sind jedoch auch andere Eigenschaften, wie Verformbarkeit, Schichthaftung, Schweißbarkeit des Endprodukts, Klebbarkeit des Endprodukts, Phosphatier- und Lackierbarkeit sowie optisches Aussehen des Endprodukts.

Durch das erfindungsgemäße Verfahren kann man nicht nur eine wesentliche Erweiterung und Verbesserung der Korrosionsschutzeigenschaften der Beschichtungen erreichen, sondern auch eine bessere Optimierung auf das gesamte Anforderungsspektrum, beispielsweise die vorgenannten Eigenschaften für spezielle Anwendungsbereiche. Beispielsweise ist mit dem erfindungsgemäßen Verfahren ein ZnMg-Legierungsüberzug mit wesentlich verbesserten Korrosionsschutzeigenschaften herstellbar.

Ferner ermöglicht das erfindungsgemäße Verfahren einen qualitativ besseren Schichtaufbau, der wiederum eine Reduktion der Schichtdicke und damit eine Verbesserung der Umform- und Schweißbarkeit des Schichtverbundes bei gleicher und sogar verbesserter Korrosionsbeständigkeit zur Folge hat.

Ebenso ist mit dem erfindungsgemäßen Verfahren die Herstellung farbiger, dekorativer Schichten, die z. B. Emaille-Überzüge substituieren können, in einfacher Weise möglich.

Als Material für das Flachzeug sind neben Stahl im Prinzip alle in Bandform herstellbaren Metalle denkbar, insbesondere auch Aluminium.

Ein weiterer erheblicher verfahrenstechnischer Vorteil des erfindungsgemäßen Verfahrens ist die Flexibilität desselben. Ein Wechsel des Beschichtungsmaterials ist in einfacher Weise durch Auswechslung des Targets möglich. Außerdem besteht keine Notwendigkeit, die verwendete Vorrichtung auf spezielle Beschichtungssysteme auszulegen, so daß auch ein und dieselbe Vorrichtung für die unterschiedlichsten Beschichtungen einsetzbar ist.

Weitere Merkmale und Vorteile der erfindungsgemäßen Lösung sind Gegenstand der nachfolgenden Beschreibung sowie der Darstellung einiger Ausführungsbeispiele. In der Zeichnung zeigen:
- Fig. 1: eine schematische Darstellung eines erfindungsgemäßen Verfahrens;
- Fig. 2: eine vergrößerte Darstellung eines Ausführungsbeispiels einer physikalischen Vorbehandlungseinheit;
- Fig. 3: eine vergrößerte Darstellung eines ersten Ausführungsbeispiels einer Beschichtungseinheit;
- Fig. 4: eine ausschnittsweise Darstellung einer ersten Möglichkeit der Ablation;
- Fig. 5: eine ausschnittweise Darstellung einer zweiten Möglichkeit einer Ablation;
- Fig. 6: eine ausschnittweise Darstellung einer dritten Möglichkeit der Ablation;
- Fig. 7: eine ausschnittweise Darstellung einer vierten Möglichkeit der Ablation;
- Fig. 8: eine Möglichkeit der Relativbewegung zwischen dem Beschichtungsteilchenstrom und dem Flachzeug;
- Fig. 9: eine Darstellung der Verteilung der Beschichtungsteilchenstromdichte (d) relativ zum Radius (r);
- Fig.10: eine weitere Möglichkeit zur Beschichtung des Flachzeugs über die gesamte Breite;
- Fig.11: eine weitere Möglichkeit zur Beschichtung des Flachzeugs über die gesamte Breite;
- Fig.12: eine weitere Möglichkeit zur Beschichtung des Flachzeugs über die gesamte Breite;
- Fig.13: eine erste Möglichkeit einer Zufuhr von Gas in den Beschichtungsteilchenstrom;
- Fig.14: eine zweite Möglichkeit einer Zufuhr von Gas zu dem Beschichtungsteilchenstrom;
- Fig.15: ein zweites Ausführungsbeispiel einer erfindungsgemäßen Beschichtungseinheit;
- Fig.16: ein drittes Ausführungsbeispiel einer erfindungsgemäßen Beschichtungseinheit, kombiniert mit einer physikalischen Aktivierung;
- Fig.17: eine Ansicht der Beschichtungseinheit gemäß Fig.16 in Richtung des Pfeils A;
- Fig.18: eine ausschnittweise Darstellung eines vierten Ausführungsbeispiels einer Beschichtungseinheit;
- Fig.19: eine Seitenansicht des vierten Ausführungsbeispiels der Beschichtungseinheit in Richtung des Pfeils C in Fig.18;
- Fig.20: ein fünftes Ausführungsbeispiel einer erfindungsgemäßen Beschichtungseinheit und
- Fig.21: ein sechstes Ausführungsbeispiel einer erfindungsgemäßen Beschichtungseinheit.

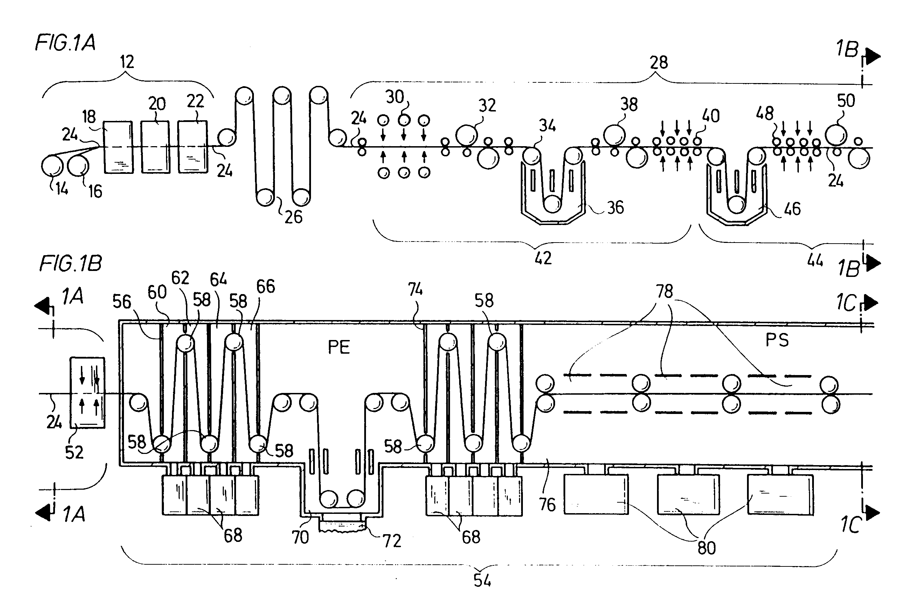

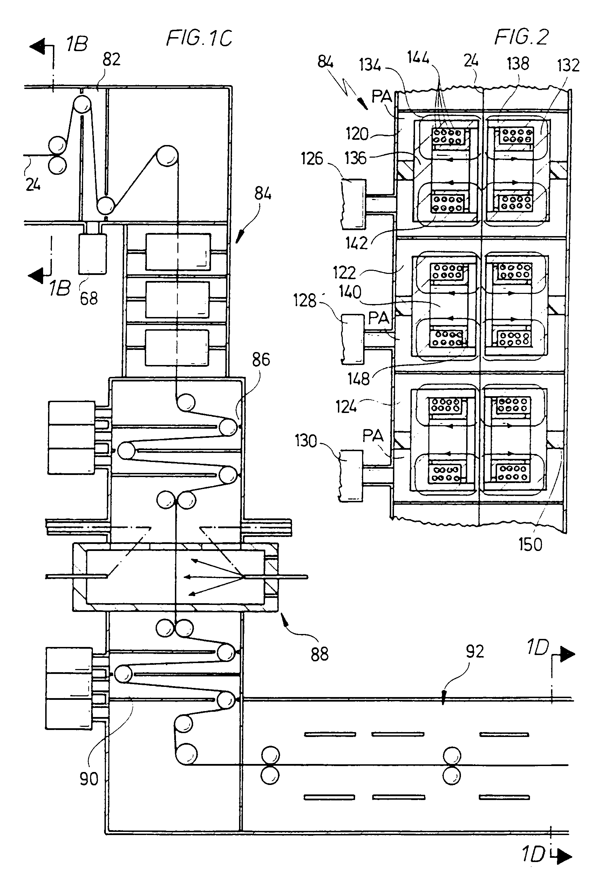

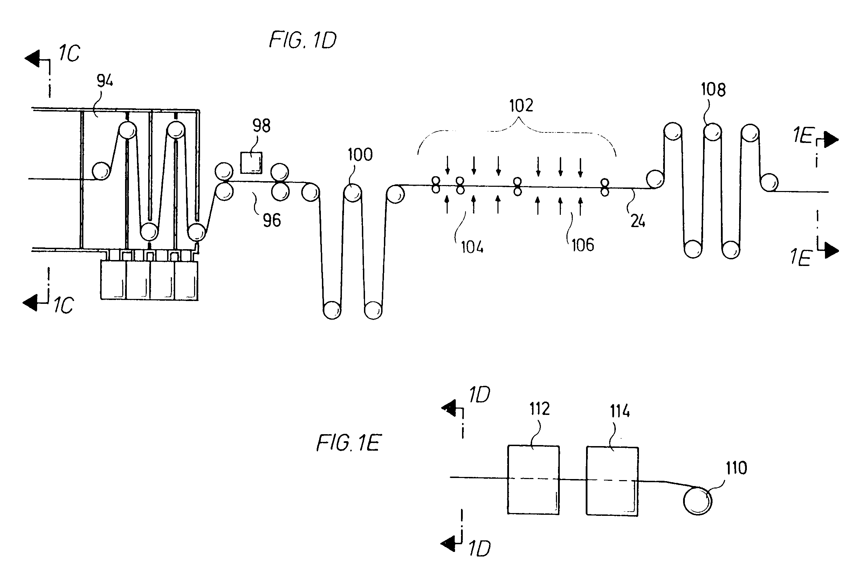

Ein Ausführungsbeispiel eines erfindungsgemäßen Prozesses, dargestellt in Fig. 1, umfaßt mehrere Einheiten.

Zunächst wird in einer mechanischen Endlosbandbereitstellungseinheit 12 auf einer Rolle 14 aufgewickeltes Flachzeug durch Abwickeln der Rolle aufgezogen und in den Prozeß eingeführt. Ein Ende des vorhergehenden Flachzeugs wird mit der Schere 18 abgeschnitten, darauffolgend wird ein Schopf von auf einer Rolle 16 aufgewickeltem Flachzeug in die Schere 18 eingeführt und von dieser so abgeschnitten, daß der Schopf des auf der Rolle 16 aufgewickelten Flachzeugs mit dem Ende des auf der Rolle 14 aufgewickelten Flachzeugs in einer Schweißmaschine 20 zu einem Endlosband 24 verschweißt werden kann. Dieser Prozeß wird ständig wiederholt, so daß der gesamte erfindungsgemäße Prozeß von einem zusammenhängenden Endlosband 24 durchlaufen wird.

Um die Planheit des Endlosbandes zu verbessern, ist vorzugsweise die mechanische Endlosbandbereitstellungseinheit 12 noch mit einer Biegestreckrichteinheit 22 versehen. Nach dieser Biegestreckrichteinheit 22 verläßt das Endlosband 24 die mechanische Endlosbandbereitstellungseinheit und tritt in einen Bandspeicher 26 ein. Dieser Bandspeicher 26 ist als vertikaler oder horizontaler Bandspeicher ausgebildet und trennt die Endlosbandbereitstellungseinheit von dem nachfolgenden Prozeß, wobei der Bandspeicher 26 dazu dient, die Vorschubunterbrechungen beim Zusammenschweißen von Ende und Schopf mittels der Schweißmaschine auszugleichen, so daß das Endlosband 24 nach dem Bandspeicher 26 mit einer konstanten Durchzugsgeschwindigkeit den erfindungsgemäßen Prozeß durchläuft.

Ein erster Teil des erfindungsgemäßen Prozesses findet in einer chemischen Vorbehandlungseinheit 28 statt. Diese chemische Vorbehandlungseinheit dient zur Reinigung und chemischen Aktivierung des Endlosbandes für die nachfolgende Beschichtung.

Die chemische Vorbehandlungseinheit umfaßt als erstes eine Spritzentfettung 30, in welcher fettlösliche Chemikalien auf das Endlosband aufgebracht werden.

Auf die Spritzentfettung 30 folgt eine Bürstmaschine 32, an welche sich dann eine elektrolytische Entfettung 34 anschließt, im Rahmen welcher das Endlosband 24 durch ein Entfettungsbad 36 gezogen wird. An die elektrolytische Entfettung schließt sich eine weitere Bürstmaschine 38 an, auf welche eine Kaskadenspülung 40 folgt. Die Kaskadenspülung 40 ist vorzugsweise mehrstufig ausgebildet und spült das Endlosband mit Wasser.

Die Spritzentfettung 30 mit der Bürstmaschine 32, der elektrolytischen Entfettung 34, der Bürstmaschine 38 und der Kaskadenspülung 40 bilden zusammen eine alkalische Entfettungseinheit 42.

An diese alkalische Entfettungseinheit 42 schließt sich eine als Ganzes mit 44 bezeichnete saure Dekapierung an, welche eine elektrolytische Zone 46, eine darauffolgende Kaskadenspülung 48 sowie eine abschließende Bürstmaschine 50 umfaßt.

Das Ende der chemischen Vorbehandlungseinheit 28 bildet eine Trocknung 52, durch welche das Endlosband 24 nach der gesamten chemischen Vorbehandlung im trockenen Zustand einer physikalischen Vorbehandlungseinheit 54 zugeführt wird.

Zu Beginn der physikalischen Vorbehandlungseinheit ist das Endlosband 24 von Atmosphäre unter Normaldruck umgeben. Daher wird zunächst in einer Schleuse 56 das Endlosband mittels Umlenkrollen 58 Zick-Zack-förmig durch mehrere Schleusenkammern 60, 62, 64 und 66 gezogen, wobei jede Schleusenkammer mit einer Vakuumpumpe 68 in Verbindung steht und in den Schleusenkammern 60 bis 66 nacheinander der das Endlosband 24 umgebende Druck auf einen Unterdruck PE in einer auf die Schleuse 56 folgenden Entgasungseinheit 70 reduziert wird. Die Entgasungseinheit 70 ist ihrerseits ebenfalls mit einer Vakuumpumpe 72 verbunden. In dieser Entgasungseinheit 70 werden alle vom Endlosband 24, insbesondere auf dessen Oberfläche, adsorbierten Teilchen, insbesondere Atome oder Moleküle, desorbiert und von der Vakuumpumpe 72 abgesaugt.

Zur Unterstützung der Desorption ist vorzugsweise noch in der Entgasungseinheit eine Behandlung des Endlosbandes 24 dahingehend vorgesehen, daß dieses entweder aufgeheizt und/oder Elektronenbeschuß und/oder Ionenbeschuß und/oder Plasmastrahlen und/oder Laserlicht und/oder UV-Licht ausgesetzt wird. Durch diese Energiezufuhr wird eine möglichst vollständige Ablösung sämtlicher vom Endlosband 24 adsorbierter Teilchen erreicht. Dadurch wird die Haftfestigkeit einer später auf dieses Endlosband 24 aufgetragenen Beschichtung verbessert.

Im Anschluß an die Entgasungseinheit 70 wird das Endlosband 24 durch eine weitere Schleuse 74 hindurchgezogen, welche genau so aufgebaut ist, wie die Schleuse 56, jedoch zur Aufgabe hat, eine Schutzgasatmosphäre 76 in einer Vorwärmeinheit 78 von der Entgasungseinheit zu trennen.

In dieser Schutzgasatmosphäre 76 erfolgt eine Aufheizung und Vorwärmung des Endlosbandes 24, beispielsweise über auf das Endlosband 24 gerichtete Strahlrohre, und/oder induktive Aufheizung des Endlosbandes 24 und/oder Aufheizung durch Infrarotstrahler und/oder Elektronenstrahlen und/oder Plasmastrahlen.

Die Schutzgasatmosphäre 76 wird jedoch auch während der Vorwärmung des Endlosbandes 24 durch Pumpen 80 auf einem bestimmten Druck PS gehalten.

Die Vorwärmeinheit 78 ist weiterhin von einer Schleuse 82 von einer physikalischen Aktivierungseinheit 84 getrennt, wobei die Schleuse 82 im Prinzip genau so aufgebaut ist wie die Schleusen 56 und 74, so daß auf die Ausführungen hierzu Bezug genommen werden kann.

Die physikalische Aktivierungseinheit 84 dient dazu, die auch nach der Entgasung noch auf dem Endlosband 24 haftenden physikalisch oder chemisch adsorbierten Teilchen zu entfernen und dadurch eine hochaktive Oberfläche zu erhalten, die Voraussetzung für eine gut haftende Beschichtung ist, wobei die physikalische Aktivierung insbesondere beim Aufbringen harter keramischer Schichten erforderlich ist.

In der physikalischen Aktivierungseinheit 84 kann eine Aktivierung des Endlosbandes erfolgen durch Elektronenbeschuß und/oder Ionenbeschuß und/oder Beschuß mit Plasmateilchen und/oder Beschuß mit Laserlicht und/oder Beschuß mit UV-Licht. Alle diese Möglichkeiten dienen dazu, durch gezielte Energiezufuhr die adsorbierten Teilchen von dem Endlosband 24 zu entfernen. Ein bevorzugtes Ausführungsbeispiel einer erfindungsgemäßen Möglichkeit einer physikalischen Aktivierung wird nachfolgend in Einzelheiten beschrieben.

Im Anschluß an die physikalische Aktivierungseinheit ist eine Schleuse 86 angeordnet, welche die physikalische Aktivierungseinheit 84 von der Beschichtungseinheit 88 trennt. In der Beschichtungseinheit erfolgt ein Auftrag einer gewünschten Beschichtung auf das Endlosband 24, wobei der Auftrag dieser Beschichtung einseitig oder beidseitig erfolgen kann.

Die Beschichtungseinheit wird im nachfolgenden in mehreren Ausführungsbeispielen detailliert beschrieben.

Im Anschluß an die Beschichtungseinheit 88 ist eine Schleuse 90 vorgesehen, so daß der Druck in der Beschichtungseinheit durch die vor- und nachgeschalteten Schleusen 86 bzw. 90 entsprechend den Anforderungen für die jeweiligen Beschichtung ohne Rücksicht auf die vor- und nachfolgenden Einheiten gewählt werden kann.

Auf die Schleuse 90 folgt eine physikalische Nachbehandlungseinheit 92, in welcher das Endlosband mit der aufgetragenen Beschichtung auf Temperatur gehalten oder zwischengekühlt wird. An diese physikalische Nachbehandlungseinheit schließt sich, durch eine Schleuse 94 getrennt, eine Meßeinrichtung 96 an, in welcher durch einen über eine Breite des Endlosbandes traversierenden Meßkopf 98 eine genaue Erfassung des aufgetragenen Beschichtung erfolgt, wobei vorzugsweise sowohl die Zusammensetzung als auch die Dicke der Schicht gemessen wird.

Nach Durchlaufen der Meßeinrichtung 96 wird das Endlosband 24 durch eine Kühleinheit 100 geführt, in welcher durch Luft und/oder Wasserkühlung das Endlosband 24 auf die gewünschte Temperatur abgekühlt wird.

Im Anschluß an die Kühleinheit 100 kann noch eine chemische Nachbehandlungseinheit 102 angeordnet sein, welche vorzugsweise eine Phosphatierung 104 und eine nachfolgende Chromatspüle 106 umfaßt.

Auf die chemische Nachbehandlungseinheit 102 folgt noch ein Bandspeicher 108, welcher ebenfalls wiederum dazu dient, zwischen dem Bandspeicher 26 und dem Bandspeicher 108 eine konstante Durchzugsgeschwindigkeit des Endlosbandes sicherzustellen, wobei nach dem Bandspeicher 108 wieder ein Aufhaspeln des Endlosbandes in einer Aufhaspeleinrichtung 110 erfolgt, vor welcher noch eine Einölmaschine 112 und zwischen dieser und dem Aushaspel 110 noch eine Schere 114 angeordnet sind. Mit der Schere 114 wird die Möglichkeit geschaffen, das Endlosband abzuschneiden und somit in einzelne Rollen bestimmter Größe aufzuwickeln.

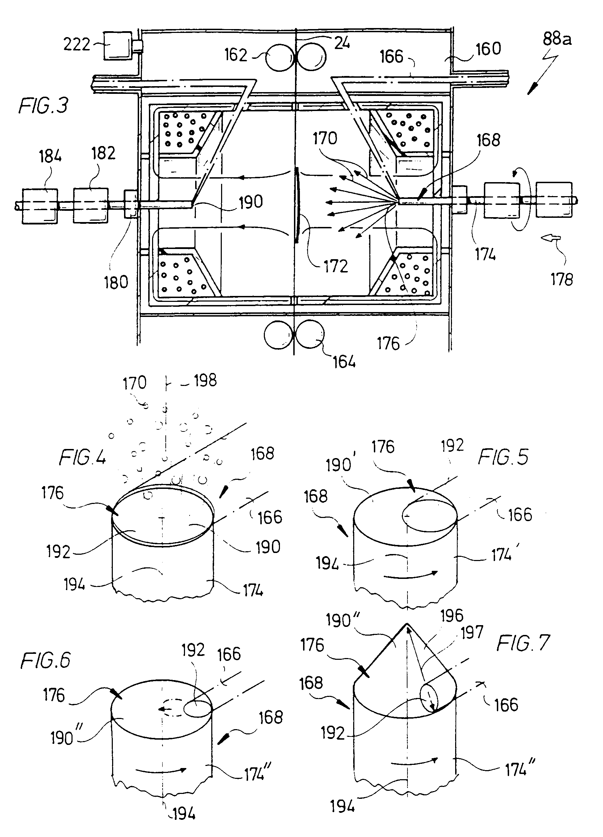

Ein Ausführungsbeispiel der physikalischen Aktivierungseinheit 84, dargestellt in Fig. 2, umfaßt mehrere aufeinanderfolgende Aktivierungskammern 120, 122 und 124, die das Endlosband 24 nacheinander durchläuft. Jede dieser Aktivierungskammern ist mit einer Vakuumpumpe 126, 128 und 130 verbunden, welche zur Erzeugung des jeweiligen Druckes PA in der jeweiligen Aktivierungskammer 120, 122 und 124 dient.

In jeder Aktivierungskammer ist eine Anode 132 vorgesehen, welche auf einer Spannung von beispielsweise 300 bis 2.000 Volt gegenüber der Kathode, gebildet durch das Endlosband 24 oder Flachzeug, liegt.

Dadurch entsteht zwischen der Anode 132 und dem als Kathode dienenden Endlosband eine Glimmentladung, durch welche ein Ionenbeschuß des Endlosbandes 24 oder Flachzeugs erfolgt.

Um den Druck PA in der Aktivierungskammer möglichst gleich dem Druck der auf die Aktivierungseinheit 84 folgenden Beschichtungseinheit 88 machen zu können, ist vorzugsweise zur Unterstützung der Glimmentladung noch ein Magnetfeld vorgesehen, dessen Feldlinien 134 im wesentlichen senkrecht von dem Endlosband 24 oder Flachzeug wegverlaufen.

Vorzugsweise sind die Anoden 132 joch- oder topfförmig ausgebildet und weisen einen Jochsteg 136 auf, welcher im wesentlichen parallel zum Endlosband 24 verläuft sowie zwei am Ende des Jochstegs 136 angeordnete und in Richtung auf das Endlosband 24 weisende Jochschenkel 138 umfaßt, die in geringem Abstand von dem Endlosband 24 enden. In einem zwischen den Jochschenkeln 138 und dem Jochsteg 136 gebildeten Jochinnenraum 140 ist eine Spule 142 angeordnet, die zur Erzeugung des Magnetfeldes dient. Die Spule 142 verläuft dabei mit ihren Windungen 144 vorzugsweise nahe der Jochschenkel 138. Zum Jochinnenraum 140 hin ist die Spule 142 noch mit einer Schutzabdeckung 148 versehen.

Die Glimmentladung verläuft, unterstützt durch die Feldlinien 134, vorzugsweise im Innern der jochförmigen Anode 132, vorzugsweise innerhalb der Spule 142 und zwischen dem Jochsteg 136 und dem diesem gegenüberliegenden Bereich des Flachzeugs oder Endlosbandes 24. Dabei ist die Anode 132 so dimensioniert, daß sich die Glimmentladung über die gesamte Breite des Endlosbandes 24 quer zur Durchgangsrichtung erstreckt.

Zweckmäßigerweise ist die Anode 132 durch eine isolierende Halterung 150 in der jeweiligen Aktivierungskammer 120, 122 oder 124 gehalten.

Um eine beidseitige physikalische Aktivierung des Endlosbandes 24 zu erreichen, ist vorzugsweise auf jeweils gegenüberliegenden Seiten des Endlosbandes 24 eine derartige Anode 132 angeordnet, so daß beidseitig des Endlosbandes 24 eine Glimmentladung zwischen den Anoden 132 und dem Endlosband 24 erzeugt wird.

Um eine möglichst effektive Aktivierung des Endlosbandes 24 zu erreichen, ist jede der Aktivierungskammern 120, 122, und 124 mit jeweils auf gegenüberliegenden Seiten des Endlosbandes 24 angeordneten Anoden 132 versehen.

Vorzugsweise wird bei der physikalischen Aktivierung mit einem Druck zwischen 1 Pa bis 5 x 10⁻² Pa (10⁻² bis 5.10⁻⁴ mb) bei Spannungen zwischen dem jeweiligen Joch 132 und dem Endlosband 24 von ungefähr 200 bis ungefähr 2000 V gearbeitet..

Ein erstes Ausführungsbeispiel 88a der Beschichtungseinheit 88 umfaßt eine Beschichtungskammer 160, durch welche das Endlosband 24 geführt ist. Zur Führung des Endlosbandes sind jeweils im Abstand voneinander angeordnete Rollenpaare 162 und 164 vorgesehen. Zwischen diesen Rollenpaaren 162 wird mittels eines Laserstrahls 166 Beschichtungsmaterial von einem Target 168 ablatiert, welches sich dann in Form eines Beschichtungsteilchenstroms 170 in Richtung auf das Endlosband 24 ausbreitet und sich auf diesem Endlosband in Form einer Beschichtung 172 niederschlägt.

Als Target 168 wird vorzugsweise eine Rundmaterialstange 174 gewählt, die so von dem Laserstrahl angestrahlt wird; daß stirnseitig der Rundmaterialstange 174 ein Ablationsbereich 176 liegt, in welchem das Beschichtungsmaterial ablatiert wird.

Die Rundmaterialstange 174 wird beispielsweise in einer Zuführrichtung 178, welche senkrecht auf dem Flachzeug oder Endlosband 24 steht, zugeführt, wobei sich die Achse der Rundmaterialstange in dieser Zuführrichtung 178 erstreckt. Dabei tritt die Rundmaterialstange 174 durch eine Zufuhrschleuse 180 von außerhalb der Beschichtungskammer 160 in diese ein.

Die Zufuhr der Rundmaterialstange 174 wird von einer Zuführeinrichtung 182 durchgeführt, welche die Rundmaterialstange so vorschiebt, daß der Ablationsbereich 176 stets denselben Abstand von dem Endlosband 24 aufweist und somit auch relativ zur Beschichtungskammer 160 stationär stehen bleibt. Dies erfordert, daß die Zuführeinrichtung 182 die Rundmaterialstange 174 stets so vorschiebt, daß im Ablationsbereich 176 die gesamte Rundmaterialstange 174 abgetragen wird.

Darüberhinaus ist neben der Zufuhreinrichtung 182 noch eine Bereitstellungseinrichtung 184 für die Rundmaterialstange 174 vorgesehen, welche dafür sorgt, daß die Rundmaterialstange 174 als endlose Stange der Beschichtungseinheit 88 zugeführt wird und hierzu beispielsweise Rundmaterialstangen begrenzter Länge miteinander zu der endlosen Rundmaterialstange 174 verbindet, wobei im einfachsten Fall ein Verschweißen oder Verkleben der Rundmaterialstangen erfolgt.

Die Ablation des Beschichtungsmaterials auf einer Stirnseite 190 der Rundmaterialstange 174 kann im einfachsten Fall so erfolgen, daß der Laserstrahl 166 so auf einen Fokusfleck 192 fokussiert wird, daß der Fokusfleck 192 die Stirnseite 190 der Rundmaterialstange 174 vollflächig überdeckt und somit auf der gesamten Stirnseite 190 eine Ablation von Beschichtungsmaterial unter Ausbildung des Beschichtungsteilchenstroms 170 erfolgt.

Dies ist jedoch nur dann möglich, wenn die Rundmaterialstange 174 eine kleine Querschnittsfläche aufweist. Diese Verhältnisse sind in Fig. 4 dargestellt.

Ist es jedoch beispielsweise aus Gründen der zuzuführenden Beschichtungsmaterialmenge erforderlich, eine dickere Rundmaterialstange 174' einzusetzen, so ist deren Stirnseite 190' wesentlich größer als der Fokusfleck 192, welcher noch eine genügend große Energiedichte aufweist, um eine Ablation des Beschichtungsmaterials zu erreichen. Diese Verhältnisse sind in Fig. 5 dargestellt.

Ist die Dicke des Rundmaterialstabs 174' so groß, daß die Ausdehnung des Fokusflecks 192 mindestens über einen Radius der Stirnseite 190' erfolgt, so ist bei einer vorteilhaften Version der erfindungsgemäßen Lösung vorgesehen, die Rundmaterialstange 174' um ihre Achse 194 rotieren zu lassen, so daß der Fokusfleck 192 im Verlauf eines Umlaufs der Rundmaterialstange 174' die gesamte Stirnseite 190' überstreicht und somit einen gleichmäßigen Abtrag des Beschichtungsmaterials gewährleistet.

Ist jedoch, wie in Fig. 6 dargestellt, der Fokusfleck 194 wesentlich kleiner als die Stirnseite 190'' der Rundmaterialstange 174'', so läßt sich ebenfalls ein gleichmäßiger stirnseitiger Abtrag von Beschichtungsmaterial dadurch erreichen, daß der Fokusfleck, gesteuert durch die Laseroptik, die Stirnseite 190'' nach einem bestimmten vorgegebenen Muster, beispielsweise durch Nachfahren einer Spirallinie, überstreicht und somit ebenfalls für einen gleichmäßigen Abtrag des Beschichtungsmaterials von der Stirnseite 190'' sorgt.

Im Gegensatz zu den Ausführungsbeispielen gemäß Fig. 4 bis 6, welche eine Ablation dergestalt vorsehen, daß die Stirnseite 190 eine im wesentlichen ebene Fläche bleibt, ist es aber auch denkbar, den Rundmaterialstab 174'' so zu ablatieren, daß dieser beispielsweise eine kegelförmige Spitze 196 aufweist, wobei der Fokusfleck 192 in entsprechender Art und Weise auf der kegelförmigen Spitze 196 wandern muß, um deren Form aufrecht zu erhalten. Hierzu kann einerseits eine Rotation um die Achse 194 vorgesehen sein und beispielsweise zusätzlich noch ein Auf- und Abfahren auf der Kegelspitze in Richtung einer Mantellinie 198.

Alternativ zum Ausbilden einer kegelförmigen Spitze ist es aber auch ebenfalls denkbar, eine kugelkappenförmige oder andere Art einer runden Spitze zu ablatieren und diese Form durch geeignete Relativbewegung des Fokusflecks 192 relativ zur Rundmaterialstange 174 aufrechtzuerhalten.

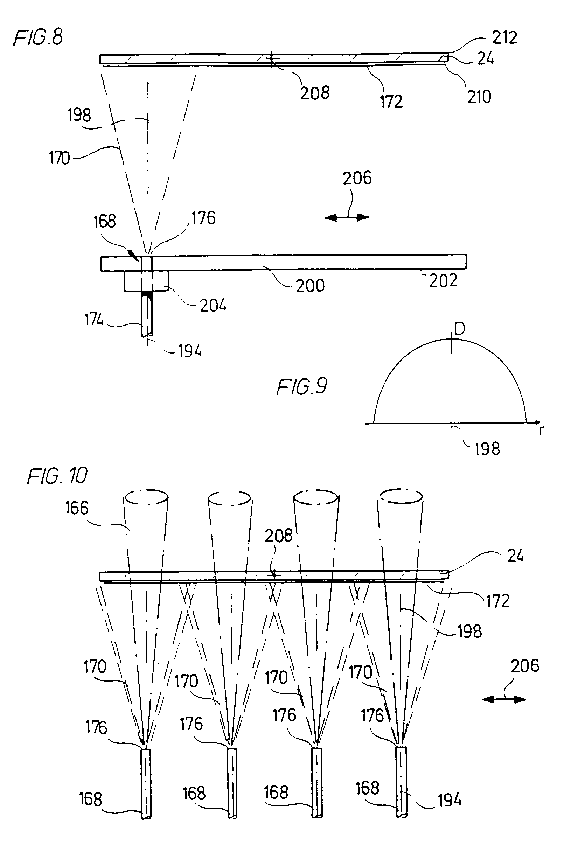

Bei der Beschreibung des Ausführungsbeispiels gemäß Fig.3 wurde lediglich davon ausgegangen, daß eine Seite des Flachzeugs oder Endlosbandes 24 von einem Beschichtungsteilchenstrom 170 beaufschlagt ist. Ein derartiger Beschichtungsteilchenstrom, ablatiert von der als Target 168 dienenden Rundmaterialstange 174, hat ausgehend von einer Mittelachse 198 in radialer Richtung gesehen, eine ungleichförmige Verteilung einer Beschichtungsteilchenstromdichte, die beispielsweise in Fig. 9 dargestellt ist.

Dadurch ist es dann, wenn eine gleichmäßige Dicke der Beschichtung 172 erreicht werden soll, nicht möglich, das Flachzeug 24 lediglich mit einem stationären Beschichtungsteilchenstrom 170 zu beaufschlagen. Wie in Fig. 8 vorgesehen, ist daher das Target 168 vorzugsweise in einer Verschiebeeinrichtung 200 gehalten, welche eine Verschiebeführung 202 und einen Verschiebeschlitten 204 umfaßt, welcher seinerseits das Target 168 trägt. Dieser Verschiebeschlitten ist in einer Querrichtung 206, welche vorzugsweise senkrecht zur Durchzugsrichtung 208 des Endlosbandes 24 und parallel zu einer Oberfläche 210 des Endlosbandes 24 verläuft, bewegbar, so daß das Target 168 gleichfalls in dieser Querrichtung 206 bewegbar ist. Vorzugsweise wird eine oszillierende Bewegung in der Querrichtung 206 beispielsweise über die gesamte Breite des Endlosbandes gewählt, so daß dadurch bei gleichzeitiger Nachführung des Laserstrahls 166 mit dessen Fokusfleck 192 eine Relativbewegung des Beschichtungsteilchenstroms 170 zum Flachzeug 24 ebenfalls in der Querrichtung 206 erfolgt, wobei die Bewegung des Beschichtungsteilchenstroms 170 vorzugsweise so gewählt wird, daß der Beschichtungsteilchenstrom 170 in den Umkehrpunkten der oszillierenden Bewegung in der Querrichtung 206 über einen seitlichen Rand 212 hinausreicht. Durch diese Bewegung in der Querrichtung 206 ist somit die Möglichkeit gegeben, eine Ausmittelung der aufgrund der unterschiedlichen Beschichtungsteilchenstromdichte entstehenden Dicke der Beschichtung durchzuführen und somit insgesamt eine Beschichtung 172 zu erreichen, welche eine im wesentlichen gleichmäßige Dicke aufweist.

Alternativ zu der in Fig. 8 dargestellten Vorrichtung ist es aber ebenfalls denkbar, in der Querrichtung 206 im Abstand voneinander angeordnete Targets 168, vorzugsweise im gleichmäßigen Abstand voneinander angeordnete Targets 168, anzuordnen und von diesen Targets ausgehend eine Ablation durchzuführen, wobei die Abstände der Targets 168 in der Querrichtung 206 so gewählt werden, daß die Summe aller von den jeweiligen Ablationsbereichen 176 ausgehenden Beschichtungsteilchenströmen 170 aufgrund deren Überlagerung insgesamt eine im wesentlichen gleichförmige Beschichtungsteilchenstromdichte über die Querrichtung 206 aufweisen.

Damit besteht lediglich die Notwendigkeit, das Endlosband 24 in der Durchzugsrichtung 208 relativ zu der Vielzahl von einander überlagernden Beschichtungsteilchenströmen zu bewegen.

Alternativ zu der Darstellung in Fig.10, bei welcher die einzelnen Targets 168 lediglich einen Abstand in der Querrichtung 206 aufweisen, ist es auch möglich, aufeinanderfolgende Targets in Durchzugrichtung 208 versetzt und in Querrichtung 206 mit Abstand voneinander anzuordnen.

Bei der in Fig. 10 dargestellten Lösung wird jeder Ablationsbereich durch einen separaten Laserstrahl 166 beaufschlagt. Erfindungsgemäß wird dies im einfachsten Fall dadurch realisiert, daß jeder Laserstrahl von einem eigenen hierzu vorgesehenen Laser kommt. Alternativ dazu ist es aber bevorzugterweise ebenfalls denkbar, einen einzigen Laserstrahl durch Strahlteiler in unterschiedliche Teilstrahlen 166 aufzuteilen, wobei vorzugsweise die unterschiedlichen Teilstrahlen 166 im wesentlichen dieselbe Intensität aufweisen.

Eine weitere erfindungsgemäße Lösung sieht vor, einen gepulsten Laser zu verwenden, welcher jeweils zwischen zwei Pulsen von einem Target 168 zum nächsten weitergeschaltet wird, so daß also keine gleichzeitige Ablation von sämtlichen Targets 168 - wie im vorstehenden beschrieben - erfolgt, sondern eine zeitlich aufeinanderfolgende Ablation. Dies ist insbesondere bei hohen Pulsfolgen eine vorteilhafte Lösung.

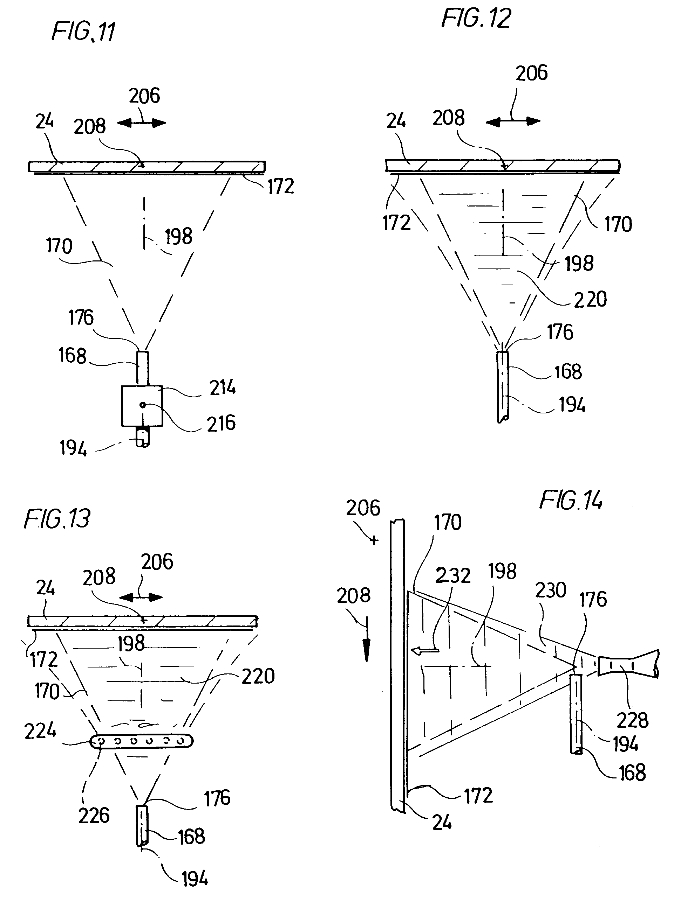

Bei einem weiteren Ausführungsbeispiel, dargestellt in Fig. 11, ist das Target 168 in einer Verschwenkeinrichtung 214 gehalten, welche das Target 168 und auch den dessen Ablationsbereich 176 beaufschlagenden Laserstrahl 166 um eine Achse 216 so verschwenkt, daß der Beschichtungsteilchenstrom 170 in der Ouerrichtung 206 über die Oberfläche 210 des Flachzeugs 24 über dessen gesamte Breite wandert und somit ebenfalls die ungleichmäßige Beschichtungsteilchenstromdichte ermittelt wird.

Eine weitere erfindungsgemäße Möglichkeit, um den in Fig. 9 im unbeeinflußten Beschichtungsteilchenstrom 170 herrschenden Beschichtungsteilchendichtegradienten auszugleichen, besteht darin, den Beschichtungsteilchenstrom 170 auf seinem Weg vom Ablationsbereich 176 zum Flachzeug 24 in eine kontrollierte Gasatmosphäre 220 eintreten zu lassen, so daß durch Stöße der Beschichtungsteilchen mit den Gasatomen oder Molekülen eine Gleichverteilung erreicht wird. Vorzugsweise hat diese Gasatmosphäre einen Druck von 1,3 x 10⁻³ Pa bis 1,3 x 10⁻² Pa (10⁻⁵ bis 10⁻⁴ Torr), wodurch eine im wesentlichen nach wie vor gerichtete Ausbreitung des Beschichtungsteilchenstroms 170 in Richtung auf das Flachzeug 24 erhalten wird, jedoch durch im Mittel 0 bis 1 Stoß mit einem Atom oder Molekül der Gasatmosphäre die Beschichtungsteilchen aus ihrer ursprünglichen Richtung abgelenkt und gleichmäßiger verteilt werden. Insbesondere bei schmalem Flachzeug 24, das heißt einer geringen Ausdehnung in der Querrichtung 206, ist ein ausreichend guter Ausgleich des Beschichtungsteilchenstromdichtegradienten erreichbar.

Ein Druck der Gasatmosphäre 220 wird vorzugsweise dadurch aufrecht erhalten, daß der Beschichtungskammer 160 ständig die Gasatmosphäre 220 bildendes Gas zugeführt und aus der Beschichtungskammer mittels einer an die Beschichtungskammer 160 angeschlossenen Vakuumpumpe 222 (Fig. 3) das die Gasatmosphäre ständig bildende Gas abgepumpt wird.

Im einfachsten Fall wird zur Bildung der Gasatmosphäre 220 ein Inertgas verwendet. Es ist aber auch möglich, wenn bestimmte chemische Verbindungen zwischen den Teilchen des Beschichtungsteilchenstroms und der Gasatmosphäre gebildet werden sollen, ein Reaktivgas zur Bildung der Gasatmosphäre 220 heranzuziehen.

Eine möglichst vorteilhafte Möglichkeit, eine derartige Gasatmosphäre 220 zwischen dem Ablationsbereich 176 und dem Flachmaterial 24 zu erzeugen, dargestellt in Fig. 13, umfaßt eine Ringleitung 224, welche den Beschichtungsteilchenstrom 170 umschließt und Düsen 226 aufweist, mittels welcher Gas in Richtung des Beschichtungsteilchenstroms 170 geblasen wird, sich mit diesem vermischt und sich somit die Gasatmosphäre 220 im Beschichtungsteilchenstrom 170 sowie auch diesen umgebend ausbildet, welche durch Stöße einen Ausgleich des Beschichtungsteilchenstroms durch den Gradienten bewirkt.

Ein noch umfangreicherer Ausgleich des Beschichtungsteilchenstromdichtegradienten ist durch Erhöhung der Zahl der Stöße und damit auch durch Erhöhung des Drucks der Gasatmosphäre möglich. Beispielsweise entstehen bei Drucken von 1,3 x 10⁻² Pa bis 13 Pa (10⁻⁴ bis 10⁻¹ Torr) im Mittel mehr als ein Stoß zwischen einem Molekül der Gasatmosphäre und einem Teilchen des Beschichtungsteilchenstroms, so daß sich in diesem Fall der Beschichtungsteilchenstrom 170 überwiegend diffusionskontrolliert ausbreitet und somit eine gerichtete Ausbreitung des Beschichtungsteilchenstroms 170 im wesentlichen nicht mehr vorliegt.

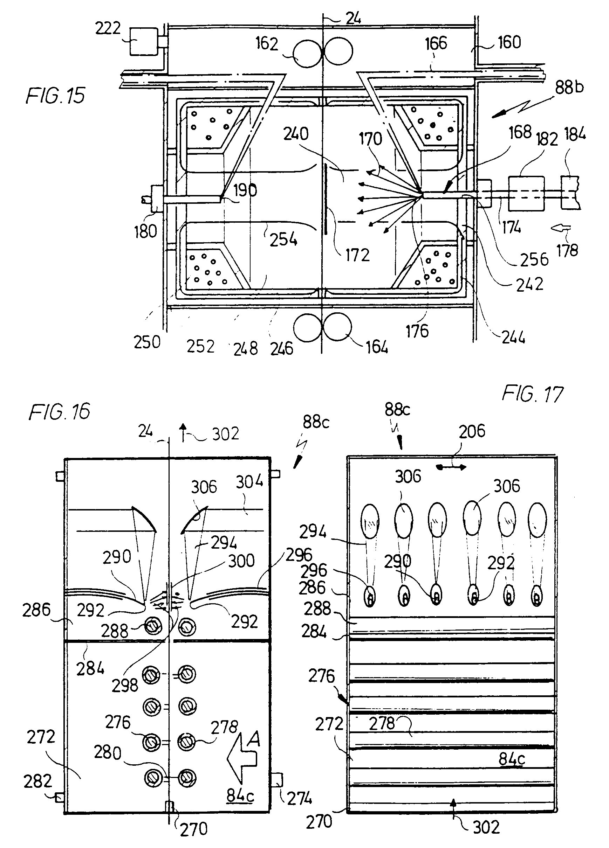

Eine weitere erfindungsgemäße Variante einer erfindungsgemäßen Lösung, dargestellt in Fig. 14, sieht vor, das Target 168 mit dem Ablationsbereich 176 in einem von einer Düse 228 ausgehenden und auf das Flachzeug 24 gerichteten Gasstrom 230 anzuordnen, wobei vorzugsweise die Ausrichtung des Ablationsbereichs 176 so gewählt wird, daß der sich ausbreitende Beschichtungsteilchenstrom 170 im wesentlichen mit dem Gasstrom 230 mitströmt. Durch den Gasstrom 230 wird nun einmal durch Stöße ein Ausgleich des Beschichtungsteilchenstromdichtegradienten erreicht und außerdem besteht die Möglichkeit, durch Variation einer mittleren Strömungsrichtung 232 des Gasstroms, beispielsweise durch Bewegen derselben in der Querrichtung 206, ein zusätzlicher Ausgleich des Beschichtungsteildichtestromgradienten im Beschichtungsteilchendichtestrom 170 zu erreichen und somit einen besseren Ausgleich des Beschichtungsteilchendichtegradienten als er lediglich bei Stoßwechselwirkung mit der Gasatmosphäre 220 erfolgt.

Bei einem besonders vorteilhaften zweiten Ausführungsbeispiel der erfindungsgemäßen Beschichtungseinheit 88b, dargestellt in Fig.15, ist dieselbe Anordnung des Targets 168 wie beim ersten Ausführungsbeispiel 88a gewählt. Insoweit als dieselben Bezugszeichen verwendet wurden, sind bei der Beschichtungseinheit 88b dieselben Teile verwendet, so daß hinsichtlich der Beschreibung derselben auf die Ausführungen zum Ausführungsbeispiel 88a verwiesen werden kann.

Im Gegensatz zur Beschichtungseinheit 88a ist bei der Beschichtungseinheit 88b eine Glimmentladung 240 vorgesehen, welche zwischen einer Anode 242 und dem Flachzeug 24 als Kathode verläuft. Die Anode 242 ist dabei vorzugsweise jochförmig angeordnet und umfaßt einen Jochsteg 244, welcher im wesentlichen parallel zum Flachzeug 24 verläuft sowie seitlich des Jochstegs angeordnete Jochschenkel 246, welche in Richtung auf das Flachzeug 24 verlaufen und einen Jochinnenraum 248 umgrenzen.

Ferner ist in dem Innenraum, und zwar im wesentlichen in den Jochschenkeln zugewandten Bereichen, eine Spule 250, vorgesehen, deren Windungen 252 im wesentlichen längs der Jochschenkel 246 umlaufen.

Vorzugsweise ist die Anode 242 topfförmig ausgebildet und erstreckt sich in der Querrichtung 206 über die gesamte Breite des Flachzeugs 24.

Die Spule 250 erzeugt dabei ein Magnetfeld, dessen Feldlinien 254 im wesentlichen senkrecht von dem Flachzeug 24 weg zum Jochsteg 244, und zwar innerhalb der Spule 250, verlaufen, während sie dann im Jochsteg 244 über die Jochschenkel 246 zurück zum Flachzeug 24 gehen. Hierzu ist vorzugsweise die Anode 242 aus einem magnetisierbaren Material hergestellt.

Die Glimmentladung 240 erstreckt sich somit, unterstützt durch die Feldlinien 254, zwischen dem Jochsteg 244 und dem Flachzeug 24 im wesentlichen innerhalb der Spule 250 und in dem die größte Feldstärke aufweisenden Bereich der Feldlinien 254.

Aus diesem Grund ist der Ablationsbereich 176 im Bereich der Glimmentladung angeordnet, wozu der Jochsteg 244 in einem mittigen Bereich mit einer Öffnung 256 versehen ist, durch welchen die Rundmaterialstange 174, von der Schleuse 180 kommend, hindurchragt.

Der sich somit von dem Ablationsbereich 176 aus ausbreitende Beschichtungsteilchenstrom 170 verläuft damit im Bereich der Glimmentladung 240, die dadurch aufrecht erhalten wird, daß in der Beschichtungskammer 160 ein Druck von 10⁻² Pa bis 1 Pa (10⁻⁴ bis 10⁻² mb) herrscht, wobei vorzugsweise dieser Druck durch eine Edelgasatmosphäre, beispielsweise Argon, aufrecht erhalten wird. Dieses Argon wird über ein Dosierventil zugeführt.

Die Ausbreitung des Beschichtungsteilchenstroms 170 in der Glimmentladung 240 führt zu mehreren physikalischen Effekten.

Zunächst erfolgt eine Stoßwechselwirkung zwischen den Beschichtungsteilchen und den Gasmolekülen oder Atomen, da das zur Glimmentladung 240 erforderliche Gas mit einem Druck von 10 Pa bis 10³ Pa (10⁻⁴ bis 10⁻² bar) vorliegt. Diese Stöße zwischen den Gasatomen oder Molekülen und den Beschichtungsteilchen führen zu einer teilweisen Thermalisierung der mit einer Energie von beispielsweise 2-10 EV sich im Beschichtungsteilchenstrom 170 bewegenden Neutralteilchen, wobei in der Regel ein geringerer Prozentsatz von einigen Prozent Ionen ebenfalls im Beschichtungsteilchenstrom 170 vorhanden ist, die bei der Laserablation im Ablationsbereich 176 entstehen.

Gleichzeitig erfolgt durch Stöße der schnellen Elektronen in der Glimmentladung eine zusätzliche Ionisierung der Beschichtungsteilchen des Beschichtungsteilchenstroms, wobei hierzu eine Mindestgröße der freien Weglänge erforderlich ist.

Sämtliche Ionen, sowohl die im Beschichtungsteilchenstrom 170 als auch die des für die Glimmentladung verantwortlichen Gases, wandern nun entsprechend der für die Glimmentladung 240 verantwortlichen Feldstärke zwischen der Anode 242 und dem Flachzeug 24 in Richtung des Flachzeugs 24.

In dem Kathodenfall erfolgt dann eine Beschleunigung sämtlicher Ionen entsprechend dem Spannungsabfall des Kathodenfalls, wobei dabei kinetische Energien von mehreren 100 eV erreichbar sind. Diese im Kathodenfall beschleunigten Ionen treffen nun auf die auf dem Flachzeug 24 aufwachsende Beschichtung 172 auf und führen dazu, daß eine insgesamt stabilere Beschichtung wächst, da die zusätzliche kinetische Energie dieser Ionen dazu führt, daß sich die Beschichtungsteilchen regelmäßiger, insbesondere unter Einnahme von gemäß den herrschenden Bindungsenergien vorteilhaften Plättchen ablagern.

Besondere Vorteile ergeben sich bei Verwendung der Glimmentladung 240 dann, wenn der Abstand zwischen dem Ablationsbereich 176 und dem Flachzeug 24 so gewählt ist, daß größenordnungsmäßig 1 bis 100 Stöße zwischen den den Beschichtungsteilchen und den Atomen oder Molekülen des die Glimmentladung 240 bildenden Gases erfolgen. In diesem Fall wird eine teilweise Thermalisierung des Beschichtungsteilchenstroms vor dessen Auftreffen auf dem Flachmaterial 24 erreicht. Insbesondere läßt sich damit ein Abbremsen der hochenergetischen Ionen, beispielsweise mit einer Energie von größenordnungsmäßig > 1000 eV, erreichen, welche die Festigkeit der Beschichtung 172 negativ beeinflussen.

Ein weiteres Ausführungsbeispiel einer erfindungsgemäßen Beschichtungseinheit 88c, kombiniert mit einer erfindungsgemäßen Aktivierungseinheit 84c, dargestellt in Fig. 16, zeigt eine Führung des Endlosbandes 24 nicht wie beim ersten Ausführungsbeispiel 84a und 88a von oben nach unten, sondern von unten nach oben. Zunächst tritt durch eine Schleuse 270 das Endlosband in eine Aktivierungskammer 272 ein, welche in einer Vakuumpumpe 274 evakuiert wird.

In dieser Aktivierungskammer ist ein Feinvakuum von 1 Pa bis 10⁻¹ Pa (10⁻² bis 10⁻³ mb).

In der Aktivierungskammer 272 sind beiderseits des Endlosbandes 24 Elektrodenstangen 276 angeordnet, welche, wie in Fig. 17 dargestellt, in der Querrichtung 206 quer zur Durchzugsrichtung des Endlosbandes 24 verlaufen und sich mindestens über die Breite des Endlosbandes 24 in Querrichtung 206 erstrecken. Diese Elektrodenstangen 276 sind mit einem Keramiküberzug 278 versehen, welcher als Dielektrikum dazu dient, ein punktförmiges Durchbrennen einer Glimmentladung zu verhindern.

Alle Elektrodenstangen 276 sind mit einem zeichnerisch nicht dargestellten Hochfrequenzgenerator verbunden, welcher eine hochfrequente Spannung zwischen dem Endlosband 24 und den Elektrodenstangen beiderseits des Endlosbandes 24 generiert, so daß ein hochfrequentes Feld zwischen den Elektrodenstangen und dem Endlosband 24 beiderseits desselben zu einer Glimmentladung 280 führt. Durch diese Glimmentladung 280 werden Ionen in Richtung auf das Endlosband 24 beschleunigt und somit das Endlosband 24 einem Ionenbeschuß unterzogen, welcher in gleicher Weise wie bei der bereits beschriebenen Aktivierungseinheit 84 dazu führt, daß sich sämtliche, noch auf dem Endlosband 24 adsorbierten Atome oder Moleküle lösen.

Unterstützt wird dieses durch das ständige Abpumpen mit der Vakuumpumpe 274. Um den Druck in der Aktivierungskammer konstant zu halten, ist ein Regelventil 282 vorgesehen, welches dosiert ein für die Glimmentladung 280 erforderliches Gas, beispielsweise ein Edelgas, in die Aktivierungskammer einleitet, um das vorgewählte Feinvakuum im Bereich von 1 Pa bis 10⁻¹ Pa (10⁻² bis 10⁻³) aufrechtzuerhalten.

Die Aktivierungskammer 272 ist zur Beschichtungseinheit 88c hin durch eine Trennwand 284 abgeschlossen, durch welche das Endlosband 24 berührungslos hindurchgeführt ist.

In einer Beschichtungskammer 286 sind zunächst beiderseits des Endlosbandes 24 wieder Elektrodenstangen 288 angeordnet, die ihrerseits ebenfalls mit einem als Dielektrikum dienenden keramischen Überzug versehen sind. Diese beiden Elektrodenstangen 288 sind ihrerseits wieder mit einer Hochfrequenzquelle verbunden, welche eine Glimmentladung zwischen den Elektrodenstangen 288 und dem Endlosband 24 erzeugt.

Darüberhinaus münden beiderseits des Endlosbandes 24 in der Beschichtungskammer jeweils als Stränge 290 ausgebildete Targets, deren vorderes Ende einen Ablationsbereich 292 bildet, welcher durch einen Laserstrahl 294 beaufschlagt ist.

Die Stränge des Beschichtungsmaterials 290 werden durch die Zuführhalterung 296 bis kurz vor den Ablationsbereich 292 geführt. Die Zuführhalterung 296 dient gleichzeitig als Schleuse, um die endlos außerhalb der Beschichtungskammer 286 zur Verfügung gestellten Stränge 290 in die Beschichtungskammer vakuumdicht einzuführen.

Vorzugsweise werden die Stränge 290 mit ihrem vorderen Ende in einem spitzen Winkel zum Endlosband 24 geführt und von Laserstrahlung beaufschlagt, welche vor der Beaufschlagung des Ablationsbereiches 292 ungefähr parallel zum Endlosband 24 reflektiert wird, so daß von dem Ablationsbereich 292 ausgehend ein Beschichtungsteilchenstrom 298 im wesentlichen senkrecht oder in einem stumpfen Winkel gegenüber dem Endlosband 24 geneigt entsteht, welcher sich in Richtung des Endlosbandes 24 ausbreitet und dort zum Auftrag der Beschichtung 300 führt.

Erfindungsgemäß wird die Ebene der Elektrodenstangen 288 so gewählt, daß sie, bezogen auf die Durchzugsrichtung 302, geringfügig stromaufwärts der Ebene liegt, in welcher die Ablationsbereiche 292 liegen. Dies hat den Zweck, daß die Glimmentladung sich in den Beschichtungsteilchenstrom 298 hinein ausbreitet und dadurch den Beschichtungsteilchenstrom 298 in der gleichen Weise moderiert wie den Beschichtungsteilchenstrom 170 in der Beschichtungseinheit 88b gemäß Fig. 15.

Die Einspiegelung des Laserstrahls 294 erfolgt vorzugsweise in Form eines parallelen Laserstrahls 304, welcher auf einen konkaven Reflexionsspiegel 306 trifft, der dann den Laserstrahl 294 auf den Ablationsbereich 292 hin fokussiert. Der Spiegel 306 dient somit sowohl zur Einspiegelung des Laserstrahls 304 in der Richtung parallel zum Endlosband 24 und gleichzeitig zur Fokussierung desselben auf den Ablationsbereich 292. Der parallele Laserstrahl 304 wird dabei vorzugsweise in einer Richtung senkrecht zur Ebene des Endlosbandes 24 eingestrahlt.

Wie in Fig. 17 im Detail dargestellt, erstrecken sich die Elektrodenstangen 288 ebenfalls über die gesamte Breite des Endlosbandes 24, vorzugsweise noch über diese hinaus.

Darüberhinaus ist in der Querrichtung 206 eine Vielzahl von Ablationsbereichen 292 aufeinanderfolgend und vorzugsweise in demselben Abstand angeordnet, so daß, ausgehend von diesen Ablationsbereichen, sich überlappende Beschichtungsteilchenströme 292 ergeben, welche aufgrund ihrer Überlappung eine im wesentlichen konstante Beschichtungsstromdichte aufweisen.

Wie ebenfalls in Fig. 17 dargestellt, wird für jeden Ablationsbereich 292 ein Laserstrahl 304 eingestrahlt und in Form des Laserstrahls 294 auf diesen Ablationsbereich fokussiert. Vorzugsweise ist zur Einstrahlung des Laserstrahls 304 ein separater Laser vorgesehen. Alternativ dazu ist es aber auch denkbar, durch eine geeignete optische Anordnung einen Laserstrahl in die Vielzahl von Laserstrahlen 304 aufzuteilen, so daß die Laserstrahlen 304 gleichzeitig einfallen, oder einen Laserstrahl zeitlich durch eine Weiterschaltoptik von Ablationsbereich 292 zu Ablationsbereich 292 weiterzuschalten.

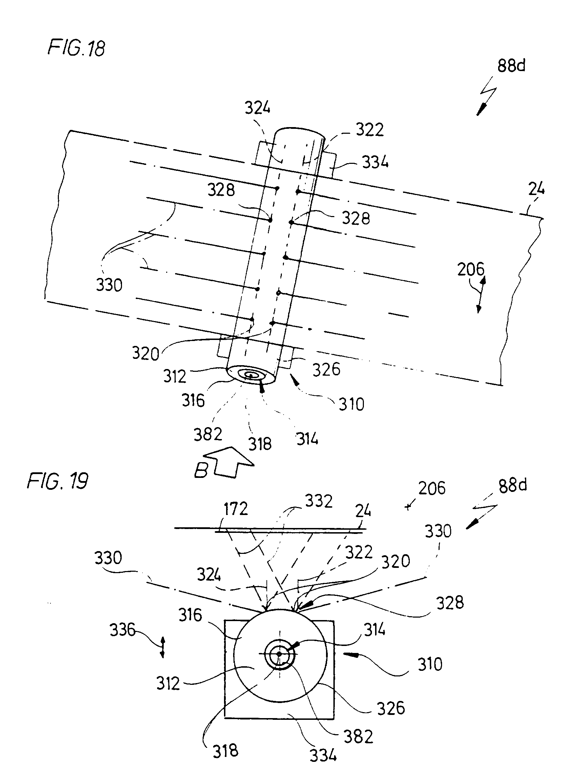

Ein weiteres Ausführungsbeispiel einer erfindungsgemäßen Beschichtungseinheit 88d, dargestellt in Fig. 18 und 19, zeigt eine grundsätzlich andere Targetanordnung.

Bei diesem Ausführungsbeispiel ist als Target 310 eine Walze 312 mit kreiszylindrischem Querschnitt vorgesehen, welche auf einem Walzenkern 314 aufgetragenes Beschichtungsmaterial 316 aufweist. Dieses Beschichtungsmaterial 316 kann ein einzelnes Element oder eine einzelne Verbindung, jedoch auch eine Mischung aus einzelnen Elementen und einzelnen Verbindungen umfassen.

Die Walze 312 ist durch ihren Walzenkern 314 um ihre Zylinderachse 318 drehbar gelagert.

Die Ablation des Beschichtungsmaterials 316 erfolgt, wie in Fig. 18 dargestellt, in einer Vielzahl von Ablationsbereichen 320, welche in zwei Reihen 322 und 324 auf einer Mantelfläche 326 der Walze 312 angeordnet sind.

Die Ablationsbereiche 320 sind dabei durch den Fokusfleck 328 der jeweiligen Laserstrahlen 330 festgelegt.

Sämtliche Laserstrahlen 330 verlaufen parallel zueinander und beaufschlagen die äquidistant in der Querrichtung 206 angeordneten Ablationsbereiche. Die von den Ablationsbereichen 320 ausgehenden Beschichtungsteilchenströme 332 überlappen sich gegenseitig und bilden einen gemeinsamen Beschichtungsteilchenstrom in Richtung auf das Endlosband 24, welcher durch die Überlagerung der einzelnen Beschichtungsteilchenströme eine im Mittel ungefähr konstante Beschichtungsteilchenstromdichte aufweist.

Vorzugsweise sind die in den beiden einander gegenüberliegenden Reihen 322 und 324 angeordneten Ablationsbereiche von von gegenüberliegenden Seiten auf die Mantelfläche 226 auftreffenden Laserstrahlen 330 beaufschlagt, wobei eine Neigung der jeweiligen Laserstrahlen 330 gegenüber einer Tangente zu der Mantelfläche 326 durch den Ablationsbereich 330 dazu ausgenutzt werden kann, die Richtung, in welcher sich der Beschichtungsteilchenstrom 332 ausbreitet, zu ändern. Dies ist insbesondere dann erforderlich, wenn ein nennenswerter Abtrag von Beschichtungsmaterial 316 von der Walze 312 erfolgt.

Um das Beschichtungsmaterial von der Walze 312 möglichst gleichmäßig abzutragen, wird die Walze um ihre Zylinderachse 318 rotiert.

Darüberhinaus ist es aber auch erforderlich, die Walze hinsichtlich des Abstandes der Ablationsbereiche 320 relativ zum Endlosband 24 nachzujustieren, nämlich so, daß dieser Abstand im wesentlichen während des gesamten Beschichtens konstant bleibt. Dies erfolgt vorzugsweise durch eine die Walze 312 um ihre Zylinderachse 318 in Drehung versetzende Antriebs- und Nachstelleinrichtung 334, welche die Walze 312 beim Drehen entsprechend dem abgetragenen Beschichtungsmaterial in der Zustellrichtung 336 auf das Endlosband 24 zu verstellt und dadurch den Abstand zwischen den Ablationsbereichen 320 und dem Endlosband 324 konstant hält.

Um die Ablation des Beschichtungsmaterials 316 von der Walze 312 möglichst über die gesamte Mantelfläche 326 konstant zu gestalten, ist vorzugsweise vorgesehen, daß die Ablationsbereiche 320 längs der Reihen 322 und 324 in der Querrichtung 206 relativ zur Mantelfläche 326 wandern. Dies ist bevorzugterweise dadurch möglich, daß die Walze 312 durch die Antriebs- und Nachstelleinrichtung 334 gleichzeitig in der Querrichtung 206 bewegt wird. Dadurch wird die Walze 312 im Bereich ihrer gesamten Mantelfläche ablatiert.

Noch vorteilhafter ist es jedoch, wenn durch Bewegung der Laserstrahlen 330 in Querrichtung die Ablationsbereiche 320 auf der feststehenden Walze in der Querrichtung 206 oszillierend hin und her wandern, da dadurch zum einen die Walze 312 auf der Mantelfläche 326 vollständig abgetragen wird, andererseits aber auch gleichzeitig die Beschichtungsteilchenströme 332 relativ zum Flachzeug oder Endlosband 24 wandern und somit ein weiterer Ausgleich eventuell lokal unterschiedlicher Beschichtungsteilchenstromdichten in der Querrichtung 206 erfolgt.

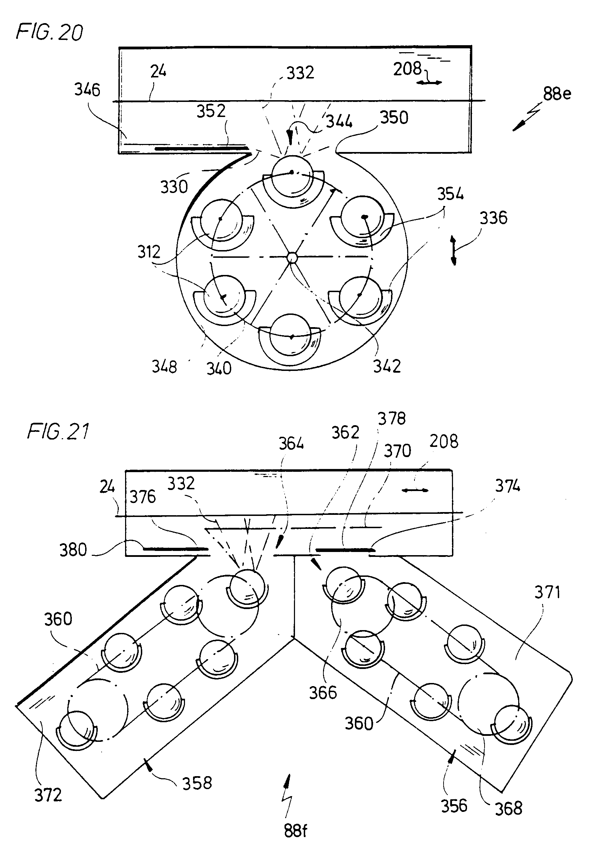

Bei einem weiteren Ausführungsbeispiel 88e der erfindungsgemäßen Beschichtungseinheit, dargestellt in Fig. 20, sind mehrere Walzen 312 in einer Revolvertrommel 340 drehbar gelagert, wobei die Revolvertrommel 340 selbst nochmals um eine Revolverachse 342 ihrerseits drehbar ist.

Durch die Revolvertrommel 340 ist nun jeweils eine der Walzen 312 in einer Targetstellung 344 positionierbar, so daß von der in dieser Targetstellung 344 stehenden Walze das Beschichtungsmaterial 316, in gleicher Weise wie bei der Beschichtungseinheit 88d beschrieben, ablatiert wird. Die gesamte Revolvertrommel 340 ist vorzugsweise nicht in einer Beschichtungskammer 346 der Beschichtungseinheit 88d angeordnet, sondern in einer von der Beschichtungskammer 346 getrennten Magazinkammer 348, wobei im Bereich der Targetstellung eine Öffnung 350 vorgesehen ist, die durch einen Schieber 352 verschließbar ist. Durch diese Öffnung kann sich der Beschichtungsteilchenstrom in die Beschichtungskammer 346 hinein ausbreiten und zu der Ausbildung der Beschichtung 172 auf dem Endlosband 24 dienen.

Damit erfindungsgemäß große Massen von Beschichtungsmaterial 16 zur Verfügung gestellt werden können, besteht nun die Möglichkeit, das Beschichtungsmaterial 316 so lange von der Walze 312 zu ablatieren, bis das Beschichtungsmaterial 316 von dieser weitgehend abgetragen ist. Danach wird nach einer kurzen Unterbrechung der Beschichtung die Revolvertrommel 340 weitergedreht, so daß die nächste Walze 312 in die Targetstellung kommt und die abgetragene Walze 312 in die Position neben der Targetstellung 344. In der Targetstellung 344 erfolgt nun mit der nächsten Walze 312 in gleicher Weise eine Fortsetzung der Beschichtung des Endlosbandes 24.

Vorzugsweise ist bei der Ausführungsform der Beschichtungseinheit 88e eine Nachstellung der jeweils in Targetstellung 344 stehenden Walze 312 dadurch vorgesehen, daß die gesamte Revolvertrommel 340, welche um die Revolverachse 342 drehbar gelagert ist, in der Zustellrichtung 336 mittels einer zeichnerisch nicht dargestellten Antriebs- und Verschiebeeinheit in Richtung auf das Endlosband 24 bewegt wird, um, genau wie bei der Beschichtungseinheit 88d den Abstand zwischen den Ablationsbereichen 320 und dem Endlosband 24 im wesentlichen konstant zu halten.

Darüberhinaus ist bei der Revolvertrommel 340, insbesondere zum Schutz der nicht in Targetstellung 344 stehenden Walzen 312, jeweils ein Auffangtrog 354 vorgesehen, welcher die in Targetstellung 344 stehende Walze im wesentlichen auf ihren den Ablationsbereichen 320 abgewandten Seiten umschließt und sämtliche, während des Ablationsprozesses von der Walze abfallenden und nicht im Beschichtungsteilchenstrom 332 in Richtung des Endlosbandes 24 transportierten Partikel oder Cluster auffängt.

Eine verbesserte Version der Beschichtungseinheit 88e ist in Fig. 21 in Form der Beschichtungseinheit 88f dargestellt. Bei dieser verbesserten Version sind die Walzen 312 jeweils auf zwei Wendespeicher 356 und 358 verteilt, welche vorzugsweise jeweils einen Endlosträger 360 aufweisen, mittels welchem jede der Walzen 312 in eine für den jeweiligen Wendespeicher 356 bzw. 358 vorgesehene Targetstellung 362 bzw. 364 transportierbar ist. Vorzugsweise kann der Endlosträger eine Transportkette sein, an welcher jede der Walzen 312 drehbar gehalten ist, die an ihren beiden Enden jeweils auf einer Tragrolle 366 bzw. 368 umlaufend geführt ist.

In den beiden Targetstellungen 362 und 364 ist jede Walze 312 durch einen Laserstrahl 370 beaufschlagbar. Erfindungsgemäß erfolgt alternativ eine Beaufschlagung entweder der Walze 312 in der Targetstellung 362 oder der Walze 312 in der Targetstellung 364.

Darüberhinaus ist jeder der Wendespeicher 356 bzw. 358 in einer separaten Magazinkammer 371 bzw. 372 angeordnet, welche jeweils durch eine Öffnung 374 bzw. 376 mit der Beschichtungskammer 346 in Verbindung steht. Jede dieser Öffnungen 374 bzw. 376 ist durch einen Schieber 378 bzw. 380 verschließbar.

Vorzugsweise arbeitet die Beschichtungseinheit 88f nun so, daß entweder der Schieber 378 oder der Schieber 380 geöffnet ist und somit eine der in Targetstellung 362 bzw. 364 stehenden Walzen 312 von dem Laserstrahl 370 zur Ablation beaufschlagbar ist. Die jeweilige Walze wird dann so lange abgetragen bis das Beschichtungsmaterial 316 weitgehend von dieser entfernt ist. Nach Abtrag des Beschichtungsmaterials von der beispielsweise in der Targetstellung 362 stehenden Walze 312 kann eine Laserablation von der ebenfalls in Targetstellung stehenden Walze 364 erfolgen, während in der Zeit, während der eine Ablation von der in der Targetstellung 364 stehenden Walze 312 erfolgt, der Wendespeicher 356 weitergeschaltet werden kann, so daß die nächste, noch in vollem Umfang mit Beschichtungsmaterial versehene Walze 312 in die Targetstellung 362 transportiert werden kann.

Nach Abtrag des Beschichtungsmaterials von der in der Targetstellung 364 stehenden Walze 312 kann nun wieder eine Ablation von der in der Targetstellung 362 stehenden und mit Beschichtungsmaterial 316 versehenen Walze 312 erfolgen.

Ferner besteht durch die Schieber 378 und 380 die Möglichkeit, jeweils die Magazinkammer 371 bzw. 372 zu verschließen und in der verschlossenen Magazinkammer, beispielsweise während der Ablation von der in der Targetstellung 362 bzw. 364 stehenden Walze des daneben liegenden Wendespeichers 356 bzw. 358 derjenige Speicher 358 bzw. 356, dessen Magazinkammer 372 bzw. 371 von der Beschichtungskammer 346 mittels des Schiebers 380 bzw. 378 getrennt ist, mitsamt den Walzen 312 auszuwechseln. Dies erfolgt beispielsweise dann, wenn das Beschichtungsmaterial von sämtlichen Walzen 312 dieses Wendespeichers 358 bzw. 356 abgetragen ist.

Alternativ dazu ist es aber auch in erfindungsgemäßer Weise denkbar, jeweils eine Position, beispielsweise die der Targetstellung 362 bzw. 364 gegenüberliegende Position des Wendespeichers 356 bzw. 358, als Auswechselposition vorzusehen, in welcher jede kein Beschichtungsmaterial 316 mehr aufweisende Walze 312 ausgewechselt und durch eine das volle Beschichtungsmaterial tragende Walze ersetzt wird.

Bei allen Walzen 312 verwendeten Beschichtungseinheiten 88d, 88e und 88f kann vorzugsweise der Walzenkern 314 so ausgebildet sein, daß er einen Kühlkanal aufweist, durch welchen ein Kühlmedium hindurchführbar ist, das den jeweiligen Walzenkern kühlt oder auch ein Temperierungsmedium, das den jeweiligen Walzenkern und somit auch die gesamte Walze 312 mitsamt dem Beschichtungsmaterial 316 auf eine gewünschte Temperatur aufheizt.

Dieser Kühlkanal ist im einfachsten Fall als axiale Bohrung 382 Fig 18 und 19 im Walzenkern 314 vorgesehen.

Ein als Träger der mechanischen Festigkeit und alle erforderlichen Konstruktionselemente enthaltende Walzenkern wird üblicherweise mit dem Beschichtungsmaterial in entsprechenden zylindrischen Formen eingegossen. Eine mechanische Nachbearbeitung der Oberfläche durch Drehen und/oder Schleifen ist erforderlich, um vollkommene Rotationssymmetrie und eine entsprechende Oberflächenausbildung des Targets zu erreichen. Erfindungsgemäß sind jedoch auch andere Arten des Aufbaus des Beschichtungsmaterials auf dem Walzenkern möglich, wie z. B. durch heißisostatisches Pulverpressen, Aufschweißen, Aufplattieren, Aufziehen von Lochscheiben oder Scheibensegmenten, etc.

## Patentansprüche

1. Verfahren zum Beschichten von Flachzeug (24) als Substratmaterial, bei welchem das Flachzeug als Endlosband (24) durch eine Unterdruck aufweisende Beschichtungskammer (160, 286, 346) kontinuierlich unter Aufrechterhaltung des für die Beschichtung erforderlichen Unterdrucks hindurchgeführt wird und bei welchem in der Unterdruck aufweisenden Beschichtungskammer (160, 286, 346) Beschichtungsmaterial (168, 290, 316) in einem Ablationsbereich (176, 292, 320) von einem Laserstrahl (166, 294, 330) ablatiert wird, sich in Form eines Beschichtungsteilchenstroms (170, 298, 332) in Richtung des Flachzeugs (24) ausbreitet und auf diesem in Form einer Beschichtung (172) abgeschieden wird,
**dadurch gekennzeichnet,**
daß der Beschichtungskammer (160, 286, 346) das erforderliche Beschichtungsmaterial (168, 290, 316) unter Aufrechterhaltung des für die Beschichtung erforderlichen Unterdrucks zugeführt wird, daß die Ablation durch den Laserstrahl (166, 294, 330) in dem Ablationsbereich (176, 292, 320) mit einer Leistungsdichte von mindestens 10⁵ W/cm² so erfolgt, daß ein exakt gerichteter Beschichtungsteilchenstrahl (170, 298, 332) erzeugt und mit diesem beschichtet wird, daß mehrere in einer Querrichtung (206) zur Durchzugsrichtung (208) im Abstand voneinander angeordnete Ablationsbereiche (176, 292, 320) vorgesehen werden und daß in diesen Ablationsbereichen (176, 292, 320) jeweils mit dem Laserstrahl (166, 294, 330) ablatiert wird.

2. Verfahren nach Anspruch 1, dadurch gekennzeichnet, daß das Beschichtungsmaterial (168, 290, 316) ohne Unterbrechung des Durchzugs des Endlosbandes (24) zugeführt wird.

3. Verfahren nach Anspruch 1 oder 2, dadurch gekennzeichnet, daß das Beschichtungsmaterial (168, 290,316) ohne Unterbrechung der Beschichtung auf dem Endlosband (24) zugeführt wird.

4. Verfahren nach einem der voranstehenden Ansprüche, dadurch gekennzeichnet, daß zum Auftragen einer gleichmäßigen Beschichtung (172) auf dem Flachzeug (24) der Beschichtungsteilchenstrom (170) relativ zum Flachzeug (24) mit einer Komponente in Querrichtung (206) zur Durchzugsrichtung (208) des Endlosbandes (24) bewegt wird.

5. Verfahren nach Anspruch 4, dadurch gekennzeichnet, daß der Beschichtungsteilchenstrom (170) mit einer Komponente in der Querrichtung (206) oszillierend verschwenkt wird.

6. Verfahren nach Anspruch 4, dadurch gekennzeichnet, daß der Beschichtungsteilchenstrom (170) mit einer Komponente in der Querrichtung (206) parallel verschoben wird.

7. Verfahren nach einem der Ansprüche 4 bis 6, dadurch gekennzeichnet, daß bei der Bewegung des Beschichtungsteilchenstroms (170) mit einer Komponente in der Querrichtung (206) ein Abstand zwischen dem Ablationsbereich (176) und dem Flachzeug (24) im wesentlichen konstant gehalten wird.

8. Verfahren nach einem der Ansprüche 4 bis 7, dadurch gekennzeichnet, daß zur Verschiebung des Beschichtungsteilchenstroms (170) mit einer Komponente in der Querrichtung (206) der Ablationsbereich (176) mit einer Komponente in der Querrichtung verschoben wird.

9. Verfahren nach einem der voranstehenden Ansprüche, dadurch gekennzeichnet, daß der Abstand der Ablationsbereiche (176, 292, 320) in der Querrichtung (206) so gewählt wird, daß sich die von den einzelnen Ablationsbereichen ausgehenden Beschichtungsteilchenströme (170, 298, 332) im wesentlichen nicht überlagern.

10. Verfahren nach einem der Ansprüche 1-8, dadurch gekennzeichnet, daß der Abstand der Ablationsbereiche (176, 292, 320) so gewählt wird, daß sich die von diesen ausgehenden Beschichtungsteilchenströme (170, 298, 332) überlagern.

11. Verfahren nach Anspruch 10, dadurch gekennzeichnet, daß der Abstand so gewählt wird, daß die einander überlagerten Beschichtungsteilchenströme (170, 298, 332) einen Gesamtbeschichtungsteilchenstrom mit einer im wesentlichen konstanten Beschichtungsteilchenstromdichte bilden.

12. Verfahren nach einem der voranstehenden Ansprüche, dadurch gekennzeichnet, daß bei den in der Querrichtung (206) im Abstand voneinander angeordneten Ablationsbereichen (176, 292, 320) nacheinander mit einem Laserstrahl (166, 294, 330) ablatiert wird.

13. Verfahren nach Anspruch 1 bis 11, dadurch gekennzeichnet, daß bei den in der Querrichtung (206) im Abstand voneinander angeordneten Ablationsbereichen (176, 292, 320) gleichzeitig jeweils mit einem Laserstrahl (166, 294, 320) ablatiert wird.

14. Verfahren nach einem der voranstehenden Ansprüche, dadurch gekennzeichnet, daß in der Durchzugsrichtung (208) des Endlosbandes (24) mehrere Ablationsbereiche (176, 292, 320) für Beschichtungsmaterial (168, 290 316) aufeinanderfolgend angeordnet sind.

15. Verfahren nach Anspruch 14, dadurch gekennzeichnet, daß das Beschichtungsmaterial (168, 290, 316) in den in Durchzugsrichtung (208) des Endlosbandes (24) aufeinanderfolgend angeordneten Ablationsbereichen (176, 292, 320) unterschiedlich ist.

16. Verfahren nach Anspruch 14 oder 15, dadurch gekennzeichnet, daß das Flachzeug (24) von einem in der Querrichtung (206) im wesentlichen eine konstante Beschichtungsteilchendichte aufweisenden ersten Beschichtungsteilchenstrom (170, 298, 332) und gleichzeitig von einem in Durchzugsrichtung (208) des Endlosbandes (24) versetzt angeordneten, in der Querrichtung (206) im wesentlichen eine konstante Beschichtungsteilchenstromdichte aufweisenden zweiten Beschichtungsteilchenstrom beschichtet wird.

17. Verfahren nach Anspruch 14 oder 15, dadurch gekennzeichnet, daß die Beschichtungsteilchenströme (170, 298, 332) dasselbe Beschichtungsmaterial (168, 290, 316) tragen.

18. Verfahren nach einem der Ansprüche 14 bis 16, dadurch gekennzeichnet, daß die Beschichtungsteilchenströme (170, 298, 332) unterschiedliches Beschichtungsmaterial (168, 290, 316) tragen.

19. Verfahren nach einem der voranstehenden Ansprüche, dadurch gekennzeichnet, daß das Beschichtungsmaterial von einer Schmelze ablatiert wird.

20. Verfahren nach einem der Ansprüche 1 bis 18, dadurch gekennzeichnet, daß das Beschichtungsmaterial (168, 290, 316) von einem Festkörper (174, 290, 312) ablatiert wird.

21. Verfahren nach Anspruch 20, dadurch gekennzeichnet, daß der Festkörper (174,, 290, 312) aus dem Beschichtungsmaterial (168, 290, 316) hergestellt ist.

22. Verfahren nach Anspruch 20 oder 21, dadurch gekennzeichnet, daß der Festkörper (174, 290, 312) aus mehreren Beschichtungsmaterialien hergestellt ist.

23. Verfahren nach Anspruch 22, dadurch gekennzeichnet, daß der Festkörper (174, 290, 312) mehrere Beschichtungsmaterialien in räumlich voneinander getrennter Anordnung aufweist.

24. Verfahren nach Anspruch 22, dadurch gekennzeichnet, daß der Festkörper (174, 290, 312) mehrere Beschichtungsmaterialien homogen vermischt aufweist.

25. Verfahren nach einem der voranstehenden Ansprüche, dadurch gekennzeichnet, daß das Beschichtungsmaterial (168, 290, 316) in Form eines Targets in die Beschichtungskammer (160, 286, 346) eingeführt wird.

26. Verfahren nach Anspruch 25, dadurch gekennzeichnet, daß der Ablationsbereich (176, 292) an einem stirnseitigen Ende des Targets (168, 290) aus Beschichtungsmaterial angeordnet ist.

27. Verfahren nach Anspruch 25, dadurch gekennzeichnet, daß der Ablationsbereich (176, 292) an einem vorderen mantelseitigen Ende des Targets (168, 290) aus Beschichtungsmaterial angeordnet ist.

28. Verfahren nach einem der Ansprüche 25 bis 27, dadurch gekennzeichnet, daß der Ablationsbereich (176, 320) durch eine Relativbewegung zwischen dem Target (168, 316) und dem Laserstrahl (166, 330) wandert.

29. Verfahren nach Anspruch 28, dadurch gekennzeichnet, daß das Wandern des Ablationsbereichs (176) zu einer konstant bleibenden Form des Targets (168) in dessen ablatierten Bereichen führt.

30. Verfahren nach einem der Ansprüche 28 oder 29, dadurch gekennzeichnet, daß die Relativbewegung zwischen Laserstrahl (166, 330) und Target (168, 316) durch ein Bewegen des Laserstrahls erfolgt.

31. Verfahren nach einem der Ansprüche 28 oder 29, dadurch gekennzeichnet, daß die Relativbewegung zwischen Laserstrahl (166, 330) und Target (168, 316) durch eine Bewegung des Targets erfolgt.

32. Verfahren nach einem der Ansprüche 25 bis 31, dadurch gekennzeichnet, daß das Target (168, 290) als endloser Strang ausgebildet ist.

33. Verfahren nach Anspruch 32, dadurch gekennzeichnet, daß der Strang (174) einen runden Querschnitt aufweist.

34. Verfahren nach Anspruch 32, dadurch gekennzeichnet, daß der Strang als Band ausgebildet wird.

35. Verfahren nach einem der Ansprüche 32 bis 34, dadurch gekennzeichnet, daß der Strang (174) durch eine Dichtschleuse (180) in die Beschichtungskammer (160) eingeführt und ständig nachgeführt wird.

36. Verfahren nach einem der Ansprüche 25 bis 31, dadurch gekennzeichnet, daß das Target (316) durch voneinander getrennte Stücke (312) aus Beschichtungsmaterial gebildet wird.

37. Verfahren nach Anspruch 36, dadurch gekennzeichnet, daß das Beschichtungsmaterial (316) in diesen Stücken (312) in die Beschichtungskammer (346) eingebracht wird.

38. Verfahren nach Anspruch 37, dadurch gekennzeichnet, daß die Stücke durch eine Schleuse (371, 372) in die Beschichtungskammer (346) eingebracht werden.

39. Verfahren nach Anspruch 37 oder 38, dadurch gekennzeichnet, daß während des Ablatierens des Beschichtungsmaterials von einem Stück (312) ein weiteres Stück (312) in die Beschichtungskammer (346) eingebracht wird.

40. Verfahren nach einem der Ansprüche 36 bis 39, dadurch gekennzeichnet, daß die Stücke die Form langgestreckter Zylinder (312) aufweisen.

41. Verfahren nach Anspruch 40, dadurch gekennzeichnet, daß die Zylinder (312) um ihre Zylinderachse (318) rotierend gelagert sind.

42. Verfahren nach Anspruch 40 oder 41, dadurch gekennzeichnet, daß die Zylinderachse (318) sich quer zur Bewegungsrichtung (208) des Endlosbandes (24) erstreckt.

43. Verfahren nach Anspruch 42, dadurch gekennzeichnet, daß die Zylinderachse (318) parallel zur Oberfläche des Flachzeugs (24) ausgerichtet ist.

44. Verfahren nach einem der Ansprüche 36 bis 43, dadurch gekennzeichnet, daß die Stücke in einer Magazinkammer (348, 371, 372) angeordnet sind.

45. Verfahren nach einem der Ansprüche 36 bis 43, dadurch gekennzeichnet, daß die Stücke (312) in einem Wendemagazin (340, 356, 358) angeordnet sind.

46. Verfahren nach Anspruch 45, dadurch gekennzeichnet, daß die Stücke (312) in dem Wendemagazin (340, 356, 358) parallel zueinander ausgerichtet sind.

47. Verfahren nach Anspruch 46, dadurch gekennzeichnet, daß die Stücke (312) in das Wendemagazin (356, 358) nachgeladen werden.

48. Verfahren nach einem der Ansprüche 45 bis 47, dadurch gekennzeichnet, daß das Wendemagazin (340, 356, 358) in der Magazinkammer (348, 371, 372) sitzt.

49. Verfahren nach einem der Ansprüche 44 bis 48, dadurch gekennzeichnet, daß die Magazinkammer und die Beschichtungskammer (346) vakuumdicht voneinander trennbar sind.

50. Verfahren nach einem der Ansprüche 44 bis 49, dadurch gekennzeichnet, daß mehrere Magazinkammern (371, 372) vorgesehen sind.

51. Verfahren nach Anspruch 49 oder 50, dadurch gekennzeichnet, daß von mindestens einem Stück (312) einer Magazinkammer (371, 372) ablatiert wird.

52. Verfahren nach Anspruch 51, dadurch gekennzeichnet, daß in der von der Beschichtungskammer (346) vakuumdicht getrennten Magazinkammer (371, 372) ein Ersetzen von durch die Ablation verbrauchten Stücken (312) erfolgt.

53. Verfahren nach einem der Ansprüche 36 bis 52, dadurch gekennzeichnet, daß die Stücke (312) von mehreren Laserstrahlen (330) gleichzeitig beaufschlagt sind und mehrere Ablationsbereiche (320) aufweisen.

54. Verfahren nach einem der Ansprüche 36 bis 53, dadurch gekennzeichnet, daß die Stücke (312) sich in Querrichtung (206) zur Bewegungsrichtung (208) des Endlosbandes (24) erstrecken.

55. Verfahren nach Anspruch 53, dadurch gekennzeichnet, daß die Ablationsbereiche (320) in der Querrichtung (206) einen Abstand voneinander aufweisen.

56. Verfahren nach einem der Ansprüche 36 bis 55, dadurch gekennzeichnet, daß durch eine Relativbewegung zwischen dem Stück (312) und dem Laserstrahl (330) der Ablationsbereich (320) wandert.

57. Verfahren nach einem der voranstehenden Ansprüche, dadurch gekennzeichnet, daß die Atome oder Moleküle des ablatierten Beschichtungsmaterials (168, 290, 316) ohne chemisch im Beschichtungsteilchenstrom (170, 298, 332) zu reagieren die Beschichtung auf dem Flachzeug (24) aufbauen.

58. Verfahren nach einem der Ansprüche 1 bis 56, dadurch gekennzeichnet, daß die Atome oder Moleküle des ablatierten Beschichtungsmaterials (168, 290, 316) in dem Beschichtungsteilchenstrom (170, 298, 332) mit einem diesen durchdringenden Reaktivgas zu einer zumindest einen Teil der Beschichtung auf dem Flachzeug (24) bildenden chemischen Verbindung reagieren.

59. Verfahren nach einem der voranstehenden Ansprüche, dadurch gekennzeichnet, daß auf den Beschichtungsteilchenstrom (170) auf seinem Weg zwischen dem Ablationsbereich (176) und dem Flachzeug (24) zur Verringerung eines Beschichtungsteilchenstromdichtegradienten in diesem Beschichtungsteilchenstrom (170) zusätzlich eingewirkt wird.

60. Verfahren nach Anspruch 59, dadurch gekennzeichnet, daß auf den Beschichtungsteilchenstrom (170) mittels weiterer Teilchen (220, 230) eingewirkt wird.

61. Verfahren nach Anspruch 60, dadurch gekennzeichnet, daß die weiteren Teilchen (220, 230) Gasteilchen sind.

62. Verfahren nach Anspruch 60 oder 61, dadurch gekennzeichnet, daß die weiteren Teilchen in Form eines auf den Beschichtungsteilchenstrom (170) auftreffenden Teilchenstroms (220) zugeführt werden.

63. Verfahren nach einem der Ansprüche 59 bis 62, dadurch gekennzeichnet, daß der Beschichtungsteilchenstrom (170) mit den weiteren Teilchen durch Stöße wechselwirkt.

64. Verfahren nach Anspruch 63, dadurch gekennzeichnet, daß der Beschichtungsteilchenstrom (170) auf seinem Weg von dem Ablationsbereich (176) zum Flachzeug (24) im Mittel mindestens ungefähr einen Stoß mit den weiteren Teilchen durchführt.

65. Verfahren nach einem der Ansprüche 59 bis 64, dadurch gekennzeichnet, daß der weitere Teilchenstrom (230) mit einer Komponente in Querrichtung (206) zur Durchzugsrichtung (208) des Endlosbandes bewegt wird und durch diese Bewegung den Beschichtungsteilchenstrom (170) in der Querrichtung (206) mitbewegt.

66. Verfahren nach einem der Ansprüche 60 bis 65, dadurch gekennzeichnet, daß durch die weiteren Teilchen (220) eine Geschwindigkeitsmoderation der Beschichtungsteilchen im Beschichtungsteilchenstrom (170) durchgeführt wird.

67. Verfahren nach Anspruch 59 bis 66, dadurch gekennzeichnet, daß auf den Beschichtungsteilchenstrom (170) mittels einer Gasentladung (240) eingewirkt wird.

68. Verfahren nach Anspruch 67, dadurch gekennzeichnet, daß die Gasentladung eine Glimmentladung (240) ist.

69. Verfahren nach Anspruch 68, dadurch gekennzeichnet, daß die Glimmentladung (240) mittels weiterer Entladungsteilchen aufrecht erhalten wird.

70. Verfahren nach Anspruch 69, dadurch gekennzeichnet, daß die weiteren Entladungsteilchen mit dem Beschichtungsteilchenstrom (170) wechselwirken.

71. Verfahren nach Anspruch 69 oder 70, dadurch gekennzeichnet, daß die weiteren Entladungsteilchen mit dem Beschichtungsteilchenstrom (170) durch Stöße wechselwirken.

72. Verfahren nach einem der Ansprüche 68 bis 71, dadurch gekennzeichnet, daß die Glimmentladung (240) durch ein Magnetfeld stabilisiert wird.

73. Verfahren nach einem der Ansprüche 59 bis 72, dadurch gekennzeichnet, daß auf den Beschichtungsteilchenstrom (170) mittels Strahlung eingewirkt wird.

74. Verfahren nach Anspruch 73, dadurch gekennzeichnet, daß auf den Beschichtungsteilchenstrom (170) mittels elektromagnetischer Strahlung eingewirkt wird.

75. Verfahren nach Anspruch 73 oder 74, dadurch gekennzeichnet, daß auf den Beschichtungsteilchenstrom (170) mittels Elektronenstrahlung eingewirkt wird.

76. Verfahren nach einem der Ansprüche 59 bis 75, dadurch gekennzeichnet, daß auf den Beschichtungsteilchenstrom (170) zur Verringerung des Beschichtungsteilchenstromgradienten selektiv mittels Strahlung eingewirkt wird.

77. Verfahren nach einem der voranstehenden Ansprüche, dadurch gekennzeichnet, daß auf den Beschichtungsteilchenstrom (170) auf seinem Weg zwischen dem Ablationsbereich (176) und dem Flachzeug (24) zur Verringerung von Energieunterschieden zwischen den Beschichtungsteilchen zusätzlich eingewirkt wird.

78. Verfahren nach Anspruch 77, dadurch gekennzeichnet, daß die Einwirkung auf den Beschichtungsteilchenstrom (170) durch Ionen erfolgt.

79. Verfahren nach Anspruch 78, dadurch gekennzeichnet, daß die Einwirkung auf den Beschichtungsteilchenstrom (170) mittels einer Glimmentladung (240) erfolgt.

80. Verfahren nach Anspruch 78 oder 79, dadurch gekennzeichnet, daß die Einwirkung auf den Beschichtungsteilchenstrom (170) mittels eines elektrischen und/oder magnetischen Feldes erfolgt.

81. Verfahren nach einem der Ansprüche 77 bis 80, dadurch gekennzeichnet, daß die Einwirkung auf den Beschichtungsteilchenstrom (170) mittels Strahlung erfolgt.

82. Verfahren nach einem der voranstehenden Ansprüche, dadurch gekennzeichnet, daß auf die Beschichtung (172) während ihres Wachstums auf dem Flachzeug (24) zur Verbesserung der Eigenschaften mittels energiereicher Teilchen eingewirkt wird.

83. Verfahren nach Anspruch 82, dadurch gekennzeichnet, daß auf die Beschichtung (172) mittels Ionenbeschuß eingewirkt wird.

84. Verfahren nach Anspruch 83, dadurch gekennzeichnet, daß auf die Beschichtung (172) mittels einer Gasentladung (240) eingewirkt wird.

85. Verfahren nach Anspruch 84, dadurch gekennzeichnet, daß auf die Beschichtung (172) mittels einer Glimmentladung (240) eingewirkt wird.

86. Verfahren nach einem der Ansprüche 82 bis 85, dadurch gekennzeichnet, daß auf die Beschichtung (172) mittels Elektronen eingewirkt wird.

87. Verfahren nach einem der voranstehenden Ansprüche, dadurch gekennzeichnet, daß das Endlosband (24) vor und hinter der Beschichtungskammer durch eine Schleuse (86, 90) geführt ist.

88. Verfahren nach Anspruch 87, dadurch gekennzeichnet, daß das Endlosband (24) in der Beschichtungskammer (160, 286, 346) berührungslos geführt wird.

89. Verfahren nach Anspruch 87 oder 88, dadurch gekennzeichnet, das Endlosband (24) in der Beschichtungskammer (160) in vertikaler Richtung geführt wird.

90. Verfahren nach einem der voranstehenden Ansprüche, dadurch gekennzeichnet, daß das Endlosband (24) durch eine mechanische Endlosbandbereitstellungseinheit (12) hergestellt wird.

91. Verfahren nach Anspruch 90, dadurch gekennzeichnet, daß auf die mechanische Endlosbandbereitstellungseinheit (12) folgend ein Bandspeicher (26) angeordnet ist.

92. Verfahren nach einem der voranstehenden Ansprüche, dadurch gekennzeichnet, daß das Endlosband (24) vor dem Beschichten mit Beschichtungsmaterial (168) durch eine chemische Vorbehandlungseinheit (28) geführt wird.

93. Verfahren nach Anspruch 92, dadurch gekennzeichnet, daß die chemische Vorbehandlungseinheit (28) eine alkalische Entfettungseinheit (42) umfaßt.

94. Verfahren nach Anspruch 93, dadurch gekennzeichnet, daß die alkalische Entfettungseinheit (42) eine Spritzentfettung (30) umfaßt.

95. Verfahren nach Anspruch 93 oder 94, dadurch gekennzeichnet, daß die alkalische Entfettungseinheit (42) eine elektrolytische Entfettung (34) umfaßt.

96. Verfahren nach Anspruch 95, dadurch gekennzeichnet, daß die elektrolytische Entfettung (34) auf die Spritzentfettung (30) folgend angeordnet ist.

97. Verfahren nach Anspruch 96, dadurch gekennzeichnet, daß die elektrolytische Entfettung (34) von der Spritzentfettung (30) durch eine Bürstmaschine (38) getrennt ist.

98. Verfahren nach einem der Ansprüche 93 bis 97, dadurch gekennzeichnet, daß zum Abschluß der alkalischen Entfettungseinheit (42) eine Kaskadenspülung (40) angeordnet ist.

99. Verfahren nach Anspruch 98, dadurch gekennzeichnet, daß der Kaskadenspülung (40) eine Bürstmaschine (38) vorgeschaltet ist.

100. Verfahren nach einem der Ansprüche 92 bis 99, dadurch gekennzeichnet, daß die chemische Vorbehandlungseinheit (28) eine saure Dekapierung (44) umfaßt.

101. Verfahren nach Anspruch 100, dadurch gekennzeichnet, daß die saure Dekapierung (44) auf die alkalische Entfettungseinheit (42) folgend angeordnet ist.

102. Verfahren nach Anspruch 100 oder 101, dadurch gekennzeichnet, daß die saure Dekapierung (44) eine elektrolytische Zone umfaßt.

103. Verfahren nach Anspruch 102, dadurch gekennzeichnet, daß auf die elektrolytische Zone (46) folgend eine Kaskadenspülung (48) angeordnet ist.

104. Verfahren nach Anspruch 103, dadurch gekennzeichnet, daß der Kaskadenspülung (48) eine Bürstmaschine vorgeschaltet ist.

105. Verfahren nach einem der Ansprüche 92 bis 104, dadurch gekennzeichnet, daß die chemische Vorbehandlungseinheit (28) abschließend einen Trockner (52) aufweist.

106. Verfahren nach einem der voranstehenden Ansprüche, dadurch gekennzeichnet, daß eine physikalische Vorbehandlungseinheit (54) vorgesehen ist.

107. Verfahren nach Anspruch 106, dadurch gekennzeichnet, daß die physikalische Vorbehandlungseinheit (54) auf die chemische Vorbehandlungseinheit (28) folgt.

108. Verfahren nach Anspruch 106 oder 107, dadurch gekennzeichnet, daß die physikalische Vorbehandlungseinheit (54) eine Entgasungseinheit (70) umfaßt.

109. Verfahren nach Anspruch 108, dadurch gekennzeichnet, daß in der Entgasungseinheit (70) zur Unterstützung der Desorption das Endlosband (24) aufgeheizt und/oder Elektronenbeschuß und/oder Ionenbeschuß und/oder Plasmastrahlung und/oder Laserlicht und/oder UV-Licht ausgesetzt wird.

110. Verfahren nach einem der Ansprüche 108 oder 109, dadurch gekennzeichnet, daß zur Aufrechterhaltung des Drucks in der Entgasungseinheit (70) dieser jeweils eine Schleuse (60, 62, 64, 66) vor- und nachgeschaltet ist.

111. Verfahren nach einem der Ansprüche 106 bis 110, dadurch gekennzeichnet, daß die physikalische Vorbehandlungseinheit (54) eine Vorwärmeinheit (78) aufweist.

112. Verfahren nach Anspruch 111, dadurch gekennzeichnet, daß in der Vorwärmeinheit (78)eine Aufheizung des Endlosbandes unter Schutzgasatmosphäre (76) durchgeführt wird.

113. Verfahren nach einem der Ansprüche 106 bis 112, dadurch gekennzeichnet, daß die physikalische Vorbehandlungseinheit (54) eine physikalische Aktivierungseinheit (84) umfaßt.

114. Verfahren nach Anspruch 113, dadurch gekennzeichnet, daß die physikalische Aktivierungseinheit (84) auf die Entgasungseinheit (70) folgend angeordnet ist.

115. Verfahren nach Anspruch 114, dadurch gekennzeichnet, daß zwischen der Entgasungseinheit (70) und der physikalischen Aktivierungseinheit (84) die Vorwärmeinheit (78) angeordnet ist.

116. Verfahren nach einem der Ansprüche 113 bis 115, dadurch gekennzeichnet, daß in der physikalischen Aktivierungseinheit eine Aktivierung des Flachzeuges (24) durch Elektronenbeschuß und/oder Ionenbeschuß und/oder Beschuß mit Plasmastrahlen und/oder Beschuß mit Laserlicht und/oder Bestrahlung mit UV-Licht erfolgt.

117. Verfahren nach einem der Ansprüche 113 bis 116, dadurch gekennzeichnet, daß der Druck in der physikalischen Aktivierungseinheit (84) größenordnungsmäßig gleich dem Druck in der Beschichtungskammer (160) ist.

118. Verfahren nach Anspruch 116, dadurch gekennzeichnet, daß der Ionenbeschuß in der physikalischen Aktivierungseinheit (54) mittels einer Glimmentladung erfolgt.

119. Verfahren nach Anspruch 118, dadurch gekennzeichnet, daß die Glimmentladung durch ein Magnetfeld (134) stabilisiert ist.

120. Verfahren nach Anspruch 118 oder 119, dadurch gekennzeichnet, daß die Glimmentladung durch thermisch emittierte Elektronen in einem Hilfsstromkreis unterstützt wird.

121. Verfahren nach einem der Ansprüche 118 bis 120, dadurch gekennzeichnet, daß die Glimmentladung in einem Druckbereich von 1 Pa bis 5 x 10⁻² Pa (10⁻² bis 5 x 10⁻⁴ mbar) erfolgt.

122. Verfahren nach einem der Ansprüche 118 bis 121, dadurch gekennzeichnet, daß die Glimmentladung durch jochförmige Anoden (132) erzeugt wird.

123. Verfahren nach Anspruch 122, dadurch gekennzeichnet, daß in den jochförmigen Anoden (132) Spulen (142) zur Erzeugung des Magnetfeldes (134) angeordnet sind.

124. Verfahren nach Anspruch 123, dadurch gekennzeichnet, daß die jochförmigen Anoden (132) aus magnetisierbarem Material sind.

125. Verfahren nach einem der Ansprüche 113 bis 124, dadurch gekennzeichnet, daß die physikalische Aktivierungseinheit (84) mehrere Aktivierungskammern umfaßt.

126. Verfahren nach einem der Ansprüche 113 bis 125, dadurch gekennzeichnet, daß die physikalische Aktivierung vor dem Beschichtungsvorgang in einer von der Beschichtungskammer (160) nicht getrennten Vorbehandlungskammer erfolgt.

127. Verfahren nach einem der Ansprüche 113 bis 125, dadurch gekennzeichnet, daß die physikalische Aktivierung in einer von der Beschichtungskammer (160) getrennten Vorbehandlungskammer erfolgt.

## Claims

1. Process for coating flat material (24) as substrate material, wherein said flat material is passed continuously as a continuous strip (24) through a coating chamber (160, 286, 346) containing a reduced pressure whilst the reduced pressure necessary for the coating is maintained and wherein coating material (168, 290, 316) is ablated in an ablation region (176, 292, 320) by a laser beam (166, 294, 330) in the coating chamber (160, 286, 346) containing a reduced pressure, propagates in the form of a coating particle stream (170, 298, 332) in the direction of the flat material (24) and is deposited thereon in the form of a coating (172), characterized in that the necessary coating material (168, 290, 316) is fed to the coating chamber (160, 286, 346) whilst the reduced pressure necessary for the coating is maintained, that the ablation by the laser beam (166, 294, 330) in the ablation region (176, 292, 320) takes place with a power density of at least 10⁵W/cm² such that a precisely oriented coating particle stream (170, 298, 332) is generated and coating carried out therewith, that several ablation regions (176, 292, 320) arranged in spaced relation to one another in a transverse direction (206) to the direction of passage (208) are provided and that ablation is carried out with the laser beam (166, 294, 330) in each of these ablation regions (176, 292, 320).

2. Process as defined in claim 1, characterized in that the coating material (168, 290, 316) is fed without interruption of the passage of the continuous strip (24).

3. Process as defined in claim 1 or 2, characterized in that the coating material (168, 290, 316) is fed without interruption of the coating on the continuous strip (24).

4. Process as defined in any one of the preceding claims, characterized in that for applying a uniform coating (172) to the flat material (24) the coating particle stream (170) is moved relative to the flat material (24) with a component in the transverse direction (206) to the direction of passage (208) of the continuous strip (24).

5. Process as defined in claim 4, characterized in that the coating particle stream (170) is swivelled oscillatingly with a component in the transverse direction (206).

6. Process as defined in claim 4, characterized in that the coating particle stream (170) is displaced parallelly with a component in the transverse direction (206).

7. Process as defined in any one of claims 4 to 6, characterized in that during the movement of the coating particle stream (170) with a component in the transverse direction (206), a space between the ablation region (176) and the flat material (24) is kept substantially constant.

8. Process as defined in any one of claims 4 to 7, characterized in that for displacing the coating particle stream (170) with a component in the transverse direction (206), the ablation region (176) is displaced with a component in said transverse direction.

9. Process as defined in any one of the preceding claims, characterized in that the space between the ablation regions (176, 292, 320) in the transverse direction (206) is chosen such that the coating particle streams (170, 298, 332) emanating from the individual ablation regions are essentially not superimposed.

10. Process as defined in any one of claims 1-8, characterized in that the space between the ablation regions (176, 292, 320) is chosen such that the coating particle streams (170, 298, 332) emanating therefrom are superimposed.

11. Process as defined in claim 10, characterized in that the space is chosen such that the coating particle streams (170, 298, 332) superimposed on one another form an overall coating particle stream with a substantially constant coating particle stream density.

12. Process as defined in any one of the preceding claims, characterized in that ablation is carried out in the ablation regions (176, 292, 320) spaced from one another in the transverse direction (206) one after the other with a laser beam (166, 294, 330).

13. Process as defined in claim 1 to 11, characterized in that ablation is carried out in the ablation regions (176, 292, 320) spaced from one another in the transverse direction (206) simultaneously with one laser beam (166, 294, 320) each.

14. Process as defined in any one of the preceding claims, characterized in that several ablation regions (176, 292, 320) for coating material (168, 290, 316) are arranged in succession in the direction of passage (208) of the continuous strip (24).

15. Process as defined in claim 14, characterized in that the coating material (168, 290, 316) differs in the ablation regions (176, 292, 320) arranged in succession in the direction of passage (208) of the continuous strip (24).

16. Process as defined in claim 14 or 15, characterized in that the flat material (24) is coated by a first coating particle stream (170, 298, 332) having essentially a constant coating particle density in the transverse direction (206) and simultaneously by a second coating particle stream arranged in offset relation in the direction of passage (208) of the continuous strip (24) and having essentially a constant coating particle stream density in the transverse direction (206).

17. Process as defined in claim 14 or 15, characterized in that the coating particle streams (170, 298, 332) carry the same coating material (168, 290, 316).

18. Process as defined in any one of claims 14 to 16, characterized in that the coating particle streams (170, 298, 332) carry different coating material (168, 290, 316).

19. Process as defined in any one of the preceding claims, characterized in that the coating material is ablated from a melt.

20. Process as defined in any one of claims 1 to 18, characterized in that the coating material (168, 290, 316) is ablated from a solid (174, 290, 312).

21. Process as defined in claim 20, characterized in that the solid (174, 290, 312) is made of the coating material (168, 290, 316).

22. Process as defined in claim 20 or 21, characterized in that the solid (174, 290, 312) is made of several coating materials.

23. Process as defined in claim 22, characterized in that the solid (174, 290, 312) comprises several coating materials arranged spatially separate from one another.

24. Process as defined in claim 22, characterized in that the solid (174, 290, 312) comprises several coating materials mixed homogeneously.

25. Process as defined in any one of the preceding claims, characterized in that the coating material (168, 290, 316) is introduced into the coating chamber (160, 286, 346) in the form of a target.

26. Process as defined in claim 25, characterized in that the ablation region (176, 292) is arranged at an end face of the target (168, 290) consisting of coating material.

27. Process as defined in claim 25, characterized in that the ablation region (176, 292) is arranged at a front lateral end of the target (168, 290) consisting of coating material.

28. Process as defined in any one of claims 25 to 27, characterized in that the ablation region (176, 320) migrates by relative movement between the target (168, 316) and the laser beam (166, 330).

29. Process as defined in claim 28, characterized in that the migration of the ablation region (176) results in a shape of the target (168) remaining constant in its ablated regions.

30. Process as defined in one of claims 28 or 29, characterized in that the relative movement between laser beam (166, 330) and target (168, 316) is brought about by movement of the laser beam.

31. Process as defined in one of claims 28 or 29, characterized in that the relative movement between laser beam (166, 330) and target (168, 316) is brought about by movement of the target.

32. Process as defined in any one of claims 25 to 31, characterized in that the target (168, 290) is in the form of a continuous strand.

33. Process as defined in claim 32, characterized in that the strand (174) has a round cross section.

34. Process as defined in claim 32, characterized in that the strand is in the form of a strip.

35. Process as defined in any one of claims 32 to 34, characterized in that the strand (174) is introduced into the coating chamber (160) through a sealed lock (180) and is constantly fed.

36. Process as defined in any one of claims 25 to 31, characterized in that the target (316) is formed by pieces (312) of coating material separated from one another.

37. Process as defined in claim 36, characterized in that the coating material (316) is introduced into the coating chamber (346) in these pieces (312).

38. Process as defined in claim 37, characterized in that the pieces are introduced into the coating chamber (346) through a lock (371, 372).

39. Process as defined in claim 37 or 38, characterized in that during the ablation of the coating material from one piece (312), a further piece (312) is introduced into the coating chamber (346).

40. Process as defined in any one of claims 36 to 39, characterized in that the pieces have the shape of elongated cylinders (312).

41. Process as defined in claim 40, characterized in that the cylinders (312) are mounted for rotation about their cylinder axis (318).

42. Process as defined in claim 40 or 41, characterized in that the cylinder axis (318) extends transversely to the direction of movement (208) of the continuous strip (24).

43. Process as defined in claim 42, characterized in that the cylinder axis (318) is aligned substantially parallel to the surface of the flat material (24).

44. Process as defined in any one of claims 36 to 43, characterized in that the pieces are arranged in a magazine chamber (348, 371, 372).

45. Process as defined in any one of claims 36 to 43, characterized in that the pieces (312) are arranged in a turning magazine (340, 356, 358).

46. Process as defined in claim 45, characterized in that the pieces (312) are aligned parallel to one another in the turning magazine (340, 356, 358).

47. Process as defined in claim 46, characterized in that the turning magazine (356, 358) is recharged with the pieces (312).

48. Process as defined in any one of claims 45 to 47, characterized in that the turning magazine (340, 356, 358) is seated in the magazine chamber (348, 371, 372).

49. Process as defined in any one of claims 44 to 48, characterized in that the magazine chamber and the coating chamber (346) are separable from one another in a vacuum-tight manner.

50. Process as defined in any one of claims 44 to 49, characterized in that several magazine chambers (371, 372) are provided.

51. Process as defined in claim 49 or 50, characterized in that ablation is carried out on at least one piece (312) from a magazine chamber (371, 372).

52. Process as defined in claim 51, characterized in that pieces (312) used up by the ablation are replaced in the magazine chamber (371, 372) separated in a vacuum-tight manner from the coating chamber (346).

53. Process as defined in any one of claims 36 to 52, characterized in that the pieces (312) are simultaneously acted upon by several laser beams (330) and have several ablation regions (320).

54. Process as defined in any one of claims 36 to 53, characterized in that the pieces (312) extend in a transverse direction (206) to the direction of movement (208) of the continuous strip (24).

55. Process as defined in claim 53, characterized in that the ablation regions (320) are spaced from one another in the transverse direction (206).

56. Process as defined in any one of claims 36 to 55, characterized in that the ablation region (320) migrates due to relative movement between the piece (312) and the laser beam (330).

57. Process as defined in any one of the preceding claims, characterized in that the atoms or molecules of the ablated coating material (168, 290, 316) build up the coating on the flat material (24) without chemically reacting in the coating particle stream (170, 298, 332).

58. Process as defined in any one of claims 1 to 56, characterized in that the atoms or molecules of the ablated coating material (168, 290, 316) react in the coating particle stream (170, 298, 332) with a reactive gas penetrating said stream to produce a chemical compound forming at least part of the coating on the flat material (24).

59. Process as defined in any one of the preceding claims, characterized in that the coating particle stream (170) is acted on additionally on its way between the ablation region (176) and the flat material (24) to reduce a coating particle stream density gradient in this coating particle stream (170).

60. Process as defined in claim 59, characterized in that the coating particle stream (170) is acted upon by means of further particles (220, 230).

61. Process as defined in claim 60, characterized in that the further particles (220, 230) are gas particles.

62. Process as defined in claim 60 or 61, characterized in that the further particles are supplied in the form of a particle stream (220) impinging on the coating particle stream (170).

63. Process as defined in any one of claims 59 to 62, characterized in that the coating particle stream (170) interacts with the further particles by collisions.

64. Process as defined in claim 63, characterized in that the coating particle stream (170) has on average at least approximately one collision with the further particles on its way from the ablation region (176) to the flat material (24).

65. Process as defined in any one of claims 59 to 64, characterized in that the further particle stream (230) is moved with a component in the transverse direction (206) to the direction of passage (208) of the continuous strip and moves the coating particle stream (170) along with it in the transverse direction (206) due to this movement.

66. Process as defined in any one of claims 60 to 65, characterized in that a velocity moderation of the coating particles in the coating particle stream (170) is carried out by the further particles (220).

67. Process as defined in claim 59 to 66, characterized in that the coating particle stream (170) is acted upon by means of a gas discharge (240).

68. Process as defined in claim 67, characterized in that the gas discharge is a glow discharge (240).

69. Process as defined in claim 68, characterized in that the glow discharge (240) is maintained by further discharge particles.

70. Process as defined in claim 69, characterized in that the further discharge particles interact with the coating particle stream (170).

71. Process as defined in claim 69 to 70, characterized in that the further discharge particles interact with the coating particle stream (170) by collisions.

72. Process as defined in any one of claims 68 to 71, characterized in that the glow discharge (240) is stabilized by a magnetic field.

73. Process as defined in any one of claims 59 to 72, characterized in that the coating particle stream (170) is acted upon by radiation.

74. Process as defined in claim 73, characterized in that the coating particle stream (170) is acted upon by electromagnetic radiation.

75. Process as defined in claim 73 or 74, characterized in that the coating particle stream (170) is acted upon by electron radiation.

76. Process as defined in any one of claims 59 to 75, characterized in that the coating particle stream (170) is acted upon selectively by radiation to decrease the coating particle stream gradient.

77. Process as defined in any one of the preceding claims, characterized in that the coating particle stream (170) is acted upon additionally on its way between the ablation region (176) and the flat material (24) to decrease energy differences between the coating particles.

78. Process as defined in claim 77, characterized in that the coating particle stream (170) is acted upon by ions.

79. Process as defined in claim 78, characterized in that the coating particle stream (170) is acted upon by a glow discharge (240).

80. Process as defined in claim 78 or 79, characterized in that the coating particle stream (170) is acted upon by an electric and/or magnetic field.

81. Process as defined in any one of claims 77 to 80, characterized in that the coating particle stream (170) is acted upon by radiation.

82. Process as defined in any one of the preceding claims, characterized in that the coating (172) is acted upon by high-energy particles during its growth on the flat material (24) to improve the characteristics.

83. Process as defined in claim 82, characterized in that the coating (172) is acted upon by ion bombardment.

84. Process as defined in claim 83, characterized in that the coating (172) is acted upon by a gas discharge (240).

85. Process as defined in claim 84, characterized in that the coating (172) is acted upon by a glow discharge (240).

86. Process as defined in any one of claims 82 to 85, characterized in that the coating (172) is acted upon by electrons.

87. Process as defined in any one of the preceding claims, characterized in that the continuous strip (24) is conducted through a lock (86, 90) preceding and following the coating chamber.

88. Process as defined in claim 87, characterized in that the continuous strip (24) is guided in a non-contacting manner in the coating chamber (160, 286, 346).

89. Process as defined in claim 87 or 88, characterized in that the continuous strip (24) is guided in a vertical direction in the coating chamber (160).

90. Process as defined in any one of the preceding claims, characterized in that the continuous strip (24) is produced by a mechanical unit (12) for providing the continuous strip.

91. Process as defined in claim 90, characterized in that a device (26) for storage of the strip is arranged so as to follow the mechanical unit (12) for providing the continuous strip.

92. Process as defined in any one of the preceding claims, characterized in that prior to the coating with coating material (168), the continuous strip (24) is conducted through a chemical pretreatment unit (28).

93. Process as defined in claim 92, characterized in that the chemical pretreatment unit (28) comprises an alkaline degreasing unit (42).

94. Process as defined in claim 93, characterized in that the alkaline degreasing unit (42) comprises a spray degreasing (30).

95. Process as defined in claim 93 or 94, characterized in that the alkaline degreasing unit (42) comprises an electrolytic degreasing (34).

96. Process as defined in claim 95, characterized in that the electrolytic degreasing (34) is arranged so as to follow the spray degreasing (30).

97. Process as defined in claim 96, characterized in that the electrolytic degreasing (34) is separated from the spray degreasing (30) by a brush machine (38).

98. Process as defined in any one of claims 93 to 97, characterized in that a cascade rinsing (40) is arranged at the end of the alkaline degreasing unit (42).

99. Process as defined in claim 98, characterized in that the cascade rinsing (40) is preceded by a brush machine (38).

100. Process as defined in any one of claims 92 to 99, characterized in that the chemical pretreatment unit (28) comprises an acid pickling (44).

101. Process as defined in claim 100, characterized in that the acid pickling (44) is arranged so as to follow the alkaline degreasing unit (42).

102. Process as defined in claim 100 or 101, characterized in that the acid pickling (44) comprises an electrolytic zone.

103. Process as defined in claim 102, characterized in that a cascade rinsing (48) is arranged so as to follow the electrolytic zone (46).

104. Process as defined in claim 103, characterized in that the cascade rinsing (48) is preceded by a brush machine.

105. Process as defined in any one of claims 92 to 104, characterized in that the chemical pretreatment unit (28) comprises a drier (52) at the end.

106. Process as defined in any one of the preceding claims, characterized in that a physical pretreatment unit (54) is provided.

107. Process as defined in claim 106, characterized in that the physical pretreatment unit (54) follows the chemical pretreatment unit (28).

108. Process as defined in claim 106 or 107, characterized in that the physical pretreatment unit (54) comprises a degassing unit (70).

109. Process as defined in claim 108, characterized in that to promote the desorption, the continuous strip (24) is heated up and/or subjected to electron bombardment and/or ion bombardment and/or plasma radiation and/or laser light and/or UV light in the degassing unit (70).

110. Process as defined in one of claims 108 or 109, characterized in that the degassing unit (70) is preceded and followed by a lock (60, 62, 64, 66) in order to maintain the pressure therein.

111. Process as defined in any one of claims 106 to 110, characterized in that the physical pretreatment unit (54) comprises a preheating unit (78).

112. Process as defined in claim 111, characterized in that the continuous strip is heated up in an inert atmosphere (76) in the preheating unit (78).

113. Process as defined in any one of claims 106 to 112, characterized in that the physical pretreatment unit (54) comprises a physical activation unit (84).

114. Process as defined in claim 113, characterized in that the physical activation unit (84) is arranged so as to follow the degassing unit (70).

115. Process as defined in claim 114, characterized in that the preheating unit (78) is arranged between the degassing unit (70) and the physical activation unit (84).

116. Process as defined in any one of claims 113 to 115, characterized in that the flat material (24) is activated in the physical activation unit by electron bombardment and/or ion bombardment and/or bombardment with plasma beams and/or bombardment with laser light and/or irradiation with UV light.

117. Process as defined in any one of claims 113 to 116, characterized in that the pressure in the physical activation unit (84) is of the same order of magnitude as the pressure in the coating chamber (160).

118. Process as defined in claim 116, characterized in that the ion bombardment is carried out in the physical activation unit (54) by means of a glow discharge.

119. Process as defined in claim 118, characterized in that the glow discharge is stabilized by a magnetic field (134).

120. Process as defined in claim 118 or 119, characterized in that the glow discharge is promoted by thermally emitted electrons in an auxiliary current circuit.

121. Process as defined in any one of claims 118 to 120, characterized in that the glow discharge takes place in a pressure range of from 1 Pa to 5 x 10⁻² Pa (10⁻² to 5 x 10⁻⁴ mbar).

122. Process as defined in any one of claims 118 to 121, characterized in that the glow discharge is generated by yoke-shaped anodes (132).

123. Process as defined in claim 122, characterized in that coils (142) for generating the magnetic field (134) are arranged in the yoke-shaped anodes (132).

124. Process as defined in claim 123, characterized in that the yoke-shaped anodes (132) are made of magnetizable material.

125. Process as defined in any one of claims 113 to 124, characterized in that the physical activation unit (84) comprises several activation chambers.

126. Process as defined in any one of claims 113 to 125, characterized in that the physical activation takes place prior to the coating procedure in a pretreatment chamber not separated from the coating chamber (160).

127. Process as defined in any one of claims 113 to 125, characterized in that the physical activation takes place in a pretreatment chamber separated from the coating chamber (160).

## Revendications

1. Procédé pour le recouvrement de produits plats (24) en tant que matière de substrat, dans lequel le produit plat est passé en continu sous la forme d'une bande sans fin (24) à travers une chambre de recouvrement (160, 286, 346) présentant une dépression, en maintenant la dépression nécessaire pour le recouvrement, et dans lequel la matière de recouvrement (168, 290, 316) est retirée par un rayon laser (166, 294, 330) dans une zone d'ablation (176, 292, 320) dans la chambre de recouvrement (160, 286, 346) présentant la dépression, se propage dans la direction du produit plat (24) sous la forme d'un écoulement de particules de recouvrement (170, 298, 332) et est déposée sur le produit plat sous une forme d'un revêtement (172), caractérisé en ce que la matière de recouvrement (168, 290, 316) nécessaire est fournie à la chambre de recouvrement (160, 286, 346) en conservant la dépression nécessaire pour le recouvrement, en ce que l'ablation par le rayon laser (166, 294, 330) a lieu dans la zone d'ablation (176, 292, 320) avec une densité superficielle de puissance d'au moins 10⁵W/cm² de façon qu'un jet de particules de recouvrement (170, 298, 332) dirigé exactement soit produit et que le recouvrement soit effectué avec celui-ci, en ce que plusieurs zones d'ablation (176, 292, 320) agencées à distance l'une de l'autre dans une direction transversale (206) par rapport à la direction de passage (208) soient prévues et en ce qu'une ablation est effectuée avec le rayon laser (166, 294, 330) dans chaque zone d'ablation (176, 292, 320).

2. Procédé suivant la revendication 1, caractérisé en ce que la matière de recouvrement (168, 290, 316) est alimentée sans interruption du passage de la bande sans fin (24).

3. Procédé suivant la revendication 1 ou 2, caractérisé en ce que la matière de recouvrement (168, 290, 316) est alimentée sans interruption du recouvrement sur la bande sans fin (24).

4. Procédé suivant l'une des revendications précédentes, caractérisé en ce que pour l'application d'un revêtement régulier (172) sur le produit plat (24), l'écoulement de particules de recouvrement (170) est déplacé par rapport au produit plat (24) avec une composante en direction transversale (206) par rapport à la direction de passage (208) de la bande sans fin (24).

5. Procédé suivant la revendication 4, caractérisé en ce que l'écoulement de particules de recouvrement (170) est déplacé en va-et-vient de façon oscillante avec une composante dans la direction transversale (206).

6. Procédé suivant la revendication 4, caractérisé en ce que l'écoulement de particules de recouvrement (170) est déplacé parallèlement avec une composante dans la direction transversale (206).

7. Procédé suivant l'une des revendications 4 à 6, caractérisé en ce que, dans le cas du déplacement de l'écoulement de particules de recouvrement (170) avec une composante dans la direction transversale (206), une distance entre la zone d'ablation (176) et le produit plat (24) est maintenue sensiblement constante.

8. Procédé suivant l'une des revendications 4 à 7, caractérisé en ce que pour le déplacement de l'écoulement de particules de recouvrement (170) avec une composante dans la direction transversale (206), la zone d'ablation (176) est déplacée avec une composante dans la direction transversale.

9. Procédé suivant l'une des revendications précédentes, caractérisé en ce que la distance des zones d'ablation (176, 292, 320) dans la direction transversale (206) est choisie de façon que les écoulements de particules de recouvrement (170, 298, 332) qui partent des zones d'ablation séparées ne se recouvrent pratiquement pas.

10. Procédé suivant l'une des revendications 1 à 8, caractérisé en ce que la distance des zones d'ablation (176, 292, 320) est choisie de façon que les écoulements de particules de recouvrement (170, 298, 332) qui partent de celles-ci se recouvrent.

11. Procédé suivant la revendication 10, caractérisé en ce que la distance est choisie de façon que les écoulements de particules de recouvrement (170, 298, 332) qui se recouvrent réciproquement forment un écoulement total de particules de recouvrement présentant une densité d'écoulement de particules de recouvrement sensiblement constante.

12. Procédé suivant l'une des revendications précédentes, caractérisé en ce que, dans le cas des zones d'ablation (176, 292, 320) agencées à distance l'une de l'autre dans la direction transversale (206), l'ablation est effectuée de façon successive avec un rayon laser (166, 294, 330).

13. Procédé suivant l'une des revendications 1 à 11, caractérisé en ce que, dans le cas des zones d'ablation (176, 292, 320) agencées à distance l'une de l'autre dans la direction transversale (206), l'ablation est effectuée simultanément chaque fois avec un rayon laser (166, 294, 330).

14. Procédé suivant l'une des revendications précédentes, caractérisé en ce que, dans la direction de passage (208) de la bande sans fin (24), plusieurs zones d'ablation (176, 292, 320) pour la matière de recouvrement (168, 290, 316) sont agencées à la suite l'une de l'autre.

15. Procédé suivant la revendication 14, caractérisé en ce que la matière de recouvrement (168, 290, 316) est différente dans les zones d'ablation (176, 292, 320) agencées à la suite l'une de l'autre dans la direction de passage (208) de la bande sans fin (24).

16. Procédé suivant la revendication 14 ou 15, caractérisé en ce que le produit plat (24) est recouvert par un premier écoulement de particules de recouvrement (170, 298, 332) présentant dans la direction transversale (206) une densité de particules de recouvrement pratiquement constante, et simultanément par un deuxième écoulement de particules de recouvrement agencé de façon décalée dans la direction de passage (208) de la bande sans fin (24) et présentant dans la direction transversale (206) une densité d'écoulement de particules de recouvrement pratiquement constante.

17. Procédé suivant la revendication 14 ou 15, caractérisé en ce que les écoulements de particules de recouvrement (170, 298, 332) portent la même matière de recouvrement (168, 290, 316).

18. Procédé suivant l'une des revendications 14 à 16, caractérisé en ce que les écoulements de particules de recouvrement (170, 298, 332) portent une matière de recouvrement différente (168, 290, 316).

19. Procédé suivant l'une des revendications précédentes, caractérisé en ce que la matière de recouvrement est retirée d'une matière fondue.

20. Procédé suivant l'une des revendication 1 à 18, caractérisé en ce que la matière de recouvrement (168, 290, 316) est retirée d'un corps solide (174, 290, 312).

21. Procédé suivant la revendication 20, caractérisé en ce que le corps solide (174, 290, 312) est fabriqué à partir de la matière de recouvrement (168, 290, 316).

22. Procédé suivant la revendication 20 ou 21, caractérisé en ce que le corps solide (174, 290, 312) est fabriqué à partir de plusieurs matières de recouvrement.

23. Procédé suivant la revendication 22, caractérisé en ce que le corps solide (174, 290, 312) présente plusieurs matières de recouvrement dans un agencement séparé l'une de l'autre dans l'espace.

24. Procédé suivant la revendication 22, caractérisé en ce que le corps solide (174, 290, 312) présente, de façon mélangée de manière homogène plusieurs matières de recouvrement.

25. Procédé suivant l'une des revendications précédentes, caractérisé en ce que la matière de recouvrement (168, 290, 316) est introduite sous la forme d'une cible dans la chambre de recouvrement (160, 286, 346).

26. Procédé suivant la revendication 25, caractérisé en ce que la zone d'ablation (176, 292) est agencée à une extrémité, du côté frontal, de la cible (168, 290) en matière de recouvrement.

27. Procédé suivant la revendication 25, caractérisé en ce que la zone d'ablation (176, 292) est agencée à une extrémité antérieure, du côté de l'enveloppe, de la cible (168, 290) en matière de recouvrement.

28. Procédé suivant l'une des revendications 25 à 27, caractérisé en ce que la zone d'ablation (176, 320) se déplace d'un mouvement relatif entre la cible (168, 316) et le rayon laser (166, 330).

29. Procédé suivant la revendication 28, caractérisé en ce que le déplacement de la zone d'ablation (176) conduit à une forme qui reste constante de la cible (168) dans ses zones d'ablation.

30. Procédé suivant l'une des revendications 28 ou 29, caractérisé en ce que le mouvement relatif entre le rayon laser (166, 330) et la cible (168, 316) est réalisé par un mouvement du rayon laser.

31. Procédé suivant l'une des revendications 28 ou 29, caractérisé en ce que le mouvement relatif entre le rayon laser (166, 330) et la cible (168, 316) est réalisé par un mouvement de la cible.

32. Procédé suivant l'une des revendications 25 à 31, caractérisé en ce que la cible (168, 290) est réalisée sous la forme d'une barre sans fin.

33. Procédé suivant la revendication 32, caractérisé en ce que la barre (174) présente une section transversale ronde.

34. Procédé suivant la revendication 32, caractérisé en ce que la barre est réalisée en forme de bande.

35. Procédé suivant l'une des revendications 32 à 34, caractérisé en ce que la barre (174) est introduite par un canal étanche (180) dans la chambre de recouvrement (160) et est constamment avancée.

36. Procédé suivant l'une des revendications 25 à 31, caractérisé en ce que la cible (316) est formée par des éléments (312) en matière de recouvrement séparés l'un de l'autre.

37. Procédé suivant la revendication 36, caractérisé en ce que la matière de recouvrement (316) est introduite dans ces éléments (312) dans la chambre de recouvrement (346).

38. Procédé suivant la revendication 37, caractérisé en ce que les éléments sont introduits par un canal (371, 372) dans la chambre de recouvrement (346).

39. Procédé suivant la revendication 37 ou 38, caractérisé en ce que pendant l'ablation de la matière de recouvrement d'un élément (312), un autre élément (312) est introduit dans la chambre de recouvrement (346).

40. Précédé suivant l'une des revendication 36 à 39, caractérisé en ce que les éléments présentent la forme de cylindres allongés (312).

41. Procédé suivant la revendication 40, caractérisé en ce que les cylindres (312) sont montés de façon à pouvoir tourner autour de leur axe de cylindre (318).

42. Procédé suivant la revendication 40 ou 41, caractérisé en ce que l'axe de cylindre (318) s'étend transversalement à la direction de déplacement (208) de la bande sans fin (24).

43. Procédé suivant la revendication 42, caractérisé en ce que l'axe de cylindre (318) est orienté parallèlement à la surface du produit plat (24).

44. Procédé suivant l'une des revendications 36 à 43, caractérisé en ce que les éléments sont agencés dans une chambre de magasin (348, 371, 372).

45. Procédé suivant l'une des revendications 36 à 43, caractérisé en ce que les éléments (312) sont agencés dans un magasin pivotant (340, 356, 358).

46. Procédé suivant la revendication 45, caractérisé en ce que les éléments (312) sont orientés parallèlement l'un à l'autre dans le magasin pivotant (340, 356, 358).

47. Procédé suivant la revendication 46, caractérisé en ce que les éléments (312) sont chargés l'un derrière l'autre dans le magasin pivotant (356, 358).

48. Procédé suivant l'une des revendications 45 à 47, caractérisé en ce que le magasin pivotant (340, 356, 358) est situé dans la chambre de magasin (348, 371, 372).

49. Procédé suivant l'une des revendications 44 à 48, caractérisé en ce que la chambre de magasin et la chambre de recouvrement (346) peuvent être séparées l'une de l'autre d'une façon étanche au vide.

50. Procédé suivant l'une des revendications 44 à 49, caractérisé en ce que plusieurs chambres de magasin (371, 372) sont prévues.

51. Procédé suivant la revendication 49 ou 50, caractérisé en ce qu'une ablation est effectuée à partir d'au moins un élément (312) d'une chambre de magasin (371, 372).

52. Procédé suivant la revendication 51, caractérisé en ce qu'un remplacement d'éléments (312) consommés par l'ablation a lieu dans la chambre de magasin (371, 372) séparée, de façon étanche au vide, de la chambre de recouvrement (346).

53. Procédé suivant l'une quelconque des revendications 36 à 52, caractérisé en ce que les éléments (312) sont sollicités simultanément par plusieurs rayons laser (330) et présentent plusieurs zones d'ablation (320).

54. Procédé suivant l'une des revendications 36 à 53, caractérisé en ce que les éléments (312) s'étendent en direction transversale (206) par rapport à la direction de déplacement (208) de la bande sans fin (24).

55. Procédé suivant la revendication 53, caractérisé en ce que les zones d'ablation (320) présentent entre elles une distance dans la direction transversale (206).

56. Procédé suivant l'une des revendications 36 à 55, caractérisé en ce que la zone d'ablation (320) se déplace à la suite d'un mouvement relatif entre l'élément (312) et le rayon laser (330).

57. Procédé suivant l'une des revendications précédentes, caractérisé en ce que les atomes ou molécules de la matière de recouvrement (168, 290, 316) qui a subi une ablation constituent le revêtement sur le produit plat (24), sans réagir chimiquement dans l'écoulement de particules de recouvrement (170, 298, 332).

58. Procédé suivant l'une des revendications 1 à 56, caractérisé en ce que les atomes ou molécules de la matière de recouvrement (168, 290, 316) qui a subi une ablation réagissent, dans l'écoulement de particules de recouvrement (170, 298, 332), avec un gaz réactif qui le traverse, en une liaison chimique qui forme au moins une partie du revêtement sur le produit plat (24).

59. Procédé suivant l'une des revendications précédentes, caractérisé en ce qu'on influence de plus l'écoulement de particules de recouvrement (170), sur son parcours entre la zone d'ablation (176) et le produit plat (24), pour la diminution d'un gradient de densité d'écoulement de particules de recouvrement dans cet écoulement de particules de recouvrement (170).

60. Procédé suivant la revendication 59, caractérisé en ce qu'on agit sur l'écoulement de particules de recouvrement (170) au moyen d'autres particules (220, 230).

61. Procédé suivant la revendication 60, caractérisé en ce que les autres particules (220, 230) sont des particules gazeuses.

62. Procédé suivant la revendication 60 ou 61, caractérisé en ce que les autres particules sont amenées sous la forme d'un écoulement de particules (220) qui rencontre l'écoulement de particules de recouvrement (170).

63. Procédé suivant l'une des revendications 50 à 62, caractérisé en ce que l'écoulement de particules de recouvrement (170) interagit par collisions avec les autres particules.

64. Procédé suivant la revendication 63, caractérisé en ce que l'écoulement de particules de recouvrement (170) exécute avec les autres particules au moins environ une collision, au milieu, sur son parcours entre la zone d'ablation (176) et le produit plat (24).

65. Procédé suivant l'une des revendications 59 à 64, caractérisé en ce que l'autre écoulement de particules (230) est déplacé avec une composante en direction transversale (206) par rapport à la direction de passage (208) de la bande sans fin et entraîne par ce déplacement l'écoulement de particules de recouvrement (170) dans la direction transversale (206).

66. Procédé suivant l'une des revendications 60 à 65, caractérisé en ce qu'une modération de vitesse des particules de recouvrement dans l'écoulement de particules de recouvrement (170) est réalisée par les autres particules (220).

67. Procédé suivant l'une des revendications 59 à 66, caractérisé en ce qu'on agit sur l'écoulement de particules de recouvrement (170) au moyen d'une décharge électrique (240).

68. Procédé suivant la revendication 67, caractérisé en ce que la décharge électrique est une décharge lumineuse (240).

69. Procédé suivant la revendication 68, caractérisé en ce que la décharge lumineuse (240) est maintenue au moyen d'autres particules de décharge.

70. Procédé suivant la revendication 69, caractérisé en ce que les autres particules de décharge interagissent avec l'écoulement de particules de recouvrement (170).

71. Procédé suivant la revendication 69 ou 70, caractérisé en ce que autres particules de décharge interagissent par collisions avec l'écoulement de particules de recouvrement (170).

72. Procédé suivant l'une des revendications 68 à 71, caractérisé en ce que la décharge lumineuse (240) est stabilisée par un champ magnétique.

73. Procédé suivant l'une des revendications 59 à 72, caractérisé en ce que l'on agit au moyen d'un rayonnement sur l'écoulement de particules de recouvrement (170).

74. Procédé suivant la revendication 73, caractérisé en ce que l'on agit au moyen d'un rayonnement électromagnétique sur l'écoulement de particules de recouvrement (170).

75. Procédé suivant la revendication 73 ou 74, caractérisé en ce l'on agit au moyen d'un rayonnement d'électrons sur l'écoulement de particules de recouvrement (170).

76. Procédé suivant l'une des revendications 59 à 75, caractérisé en ce l'on agit sélectivement au moyen d'un rayonnement sur l'écoulement de particules de recouvrement (170) pour la diminution du gradient d'écoulement de particules de recouvrement.

77. Procédé suivant l'une des revendications précédentes, caractérisé en ce que l'on agit de plus sur l'écoulement de particules de recouvrement (170), sur son parcours entre la zone d'ablation (176) et le produit plat (24), pour la diminution de différences d'énergie entre les particules de recouvrement.

78. Procédé suivant la revendication 77, caractérisé en ce que l'action sur l'écoulement de particules de recouvrement (170) est effectuée par des ions.

79. Procédé suivant la revendication 78, caractérisé en ce que l'action sur l'écoulement de particules de recouvrement (170) est effectuée au moyen d'une décharge lumineuse (240).

80. Procédé suivant la revendication 78 ou 79, caractérisé en ce que l'action sur l'écoulement de particules de recouvrement (170) est effectuée au moyen d'un champ électrique et/ou magnétique.

81. Procédé suivant l'une des revendications 77 à 80, caractérisé en ce que l'action sur l'écoulement de particules de recouvrement (170) est effectuée au moyen d'un rayonnement.

82. Procédé suivant l'une des revendications précédentes, caractérisé en ce que, pour l'amélioration des propriétés, l'on agit sur le revêtement (172), pendant sa croissance sur le produit plat (24), au moyen de particules riches en énergie.

83. Procédé suivant la revendication 82, caractérisé en ce que l'on agit sur le revêtement (172) au moyen de bombardement ionique.

84. Procédé suivant la revendication 83, caractérisé en ce que l'on agit sur le revêtement (172) au moyen d'une décharge électrique (240).

85. Procédé suivant la revendication 83, caractérisé en ce que l'on agit sur le revêtement (172) au moyen d'une décharge lumineuse (240).

86. Procédé suivant l'une des revendications 82 à 85, caractérisé en ce que l'on agit sur le revêtement (172) au moyen d'électrons.

87. Procédé suivant l'une des revendications précédentes, caractérisé en ce que la bande sans fin (24) est guidée, avant et après la chambre de recouvrement, par un canal (86, 90).

88. Procédé suivant la revendication 87, caractérisé en ce que la bande sans fin (24) est guidée sans contact dans la chambre de recouvrement (160, 286, 346).

89. Procédé suivant la revendication 87 ou 88, caractérisé en ce que la bande sans fin (24) est guidée dans une direction verticale dans la chambre de recouvrement (160).

90. Procédé suivant l'une des revendications précédentes, caractérisé en ce que la bande sans fin (24) est fabriquée par un ensemble mécanique (12) de préparation de bande sans fin.

91. Procédé suivant la revendication 90, caractérisé en ce qu'un accumulateur de bande (26) est agencé à la suite de l'ensemble mécanique (12) de préparation de bande sans fin.

92. Procédé suivant l'une des revendications précédentes, caractérisé en ce que la bande sans fin (24) est amenée, avant le recouvrement avec de la matière de recouvrement (168), à travers un ensemble de traitement chimique préalable (28).

93. Procédé suivant la revendication 92, caractérisé en ce que l'ensemble de traitement chimique préalable (28) comporte un ensemble de dégraissage alcalin (42).

94. Procédé suivant la revendication 93, caractérisé en ce que l'ensemble de dégraissage alcalin (42) comporte un dégraissage par jet (30).

95. Procédé suivant la revendication 93 ou 94, caractérisé en ce que l'ensemble de dégraissage alcalin (42) comporte un dégraissage électrolytique (34).

96. Procédé suivant la revendication 95, caractérisé en ce que le dégraissage électrolytique (34) est agencé à la suite du dégraissage par jet (30).

97. Procédé suivant la revendication 96, caractérisé en ce que le dégraissage électrolytique (34) est séparé du dégraissage par jet (30) par une machine de brossage (38).

98. Procédé suivant l'une des revendications 93 à 97, caractérisé en ce qu'un rinçage en cascade (40) est agencé pour terminer l'ensemble de dégraissage alcalin (42).

99. Procédé suivant la revendication 98, caractérisé en ce qu'une machine de brossage (38) est montée avant le rinçage en cascade (40).

100. Procédé suivant l'une des revendications 92 à 99, caractérisé en ce que l'ensemble de traitement chimique préalable (28) comporte un décapage acide (44).

101. Procédé suivant la revendication 100, caractérisé en ce que le décapage acide (44) est agencé à la suite de l'ensemble de dégraissage alcalin (42).

102. Procédé suivant la revendication 100 ou 101, caractérisé en ce que le dispositif de décapage acide (44) comporte une zone électrolytique.

103. Procédé suivant la revendication 102, caractérisé en ce qu'un rinçage en cascade (48) est agencé à la suite de la zone électrolytique (46).

104. Procédé suivant la revendication 103, caractérisé en qu'une machine de brossage est montée avant le rinçage en cascade (48).

105. Procédé suivant l'une des revendications 92 à 104, caractérisé en ce que l'ensemble de traitement chimique préalable (28) présente pour terminer un sécheur (52).

106. Procédé suivant l'une des revendications précédentes, caractérisé en ce qu'est prévu un ensemble de traitement physique préalable (54).

107. Procédé suivant la revendication 106, caractérisé en ce que l'ensemble de traitement physique préalable (54) suit l'ensemble de traitement chimique préalable (28).

108. Procédé suivant la revendication 106 ou 107, caractérisé en ce que l'ensemble de traitement physique préalable (54) comporte un ensemble de dégazage (70).

109. Procédé suivant la revendication 108, caractérisé en ce que dans l'ensemble de dégazage (70), pour aider le désorption, la bande sans fin (24) est chauffée et/ou est soumise à un bombardement d'électrons et/ou à un bombardement d'ions et/ou à rayonnement de plasma et/ou à une lumière laser et/ou à une lumière ultraviolette.

110. Procédé suivant l'une des revendications 108 et 109, caractérisé en ce que pour le maintien de la pression dans l'unité de dégazage (70), un canal (60, 62, 64, 66) est monté respectivement devant et derrière celle-ci.

111. Procédé suivant l'une des revendications 106 à 110, caractérisé en ce que l'ensemble de traitement physique préalable (54) présente un ensemble de préchauffage (78).

112. Procédé suivant la revendication 111, caractérisé en ce qu'un chauffage de la bande sans fin est réalisé sous une atmosphère de gaz de protection (76) dans l'ensemble de préchauffage (78).

113. Procédé suivant l'une des revendications 106 à 112, caractérisé en ce que l'ensemble de traitement physique préalable (54) comporte un ensemble d'activation physique (84).

114. Procédé suivant la revendication 113, caractérisé en ce que l'ensemble d'activation physique (84) est agencé à la suite de l'ensemble de dégazage (70).

115. Procédé suivant la revendication 114, caractérisé en ce que l'ensemble de préchauffage (78) est agencé entre l'ensemble de dégazage (70) et l'ensemble d'activation physique (84).

116. Procédé suivant l'une des revendications 113 à 115, caractérisé en ce que dans l'ensemble d'activation physique, une activation du produit plat (24) a lieu par bombardement d'électrons et/ou par bombardement d'ions et/ou par bombardement avec des rayons de plasma et/ou par bombardement avec de la lumière laser et/ou par une exposition à de la lumière ultraviolette.

117. Procédé suivant l'une des revendications 113 à 116, caractérisé en ce que la pression dans l'ensemble d'activation physique (84) est d'un ordre de grandeur égal à la pression dans la chambre de recouvrement (160).

118. Procédé suivant la revendication 116, caractérisé en ce que le bombardement d'ions dans l'ensemble d'activation physique (54) est effectué au moyen d'une décharge lumineuse.

119. Procédé suivant la revendication 118, caractérisé en ce que la décharge lumineuse est stabilisée par un champ magnétique (134).

120. Procédé suivant la revendication 118 ou 119, caractérisé en ce que la décharge lumineuse est aidée par des électrons, émis thermiquement, dans un circuit de courant auxiliaire.

121. Procédé suivant l'une des revendications 118 à 120, caractérisé en ce que la décharge lumineuse a lieu dans une plage de pression de 1Pa à 5 x 10⁻² Pa (10⁻² à 5 x 10⁻⁴ mbar).

122. Procédé suivant l'une des revendications 118 à 121, caractérisé en ce que la décharge lumineuse est produite par des anodes (132) en forme d'arche.

123. Procédé suivant la revendication 122, caractérisé en ce que des bobines (142) sont agencées dans les anodes en forme d'arche (132) pour la production du champ magnétique (134).

124. Procédé suivant la revendication 123, caractérisé en ce que les anodes en forme d'arche (132) sont en une matière magnétisable.

125. Procédé suivant l'une des revendications 113 à 124, caractérisé en ce que l'ensemble d'activation physique (84) comporte plusieurs chambres d'activation.

126. Procédé suivant l'une des revendications 113 à 125, caractérisé en ce que l'activation physique a lieu avant le processus de recouvrement, dans une chambre de traitement préalable qui n'est pas séparée de la chambre de recouvrement (160).

127. Procédé suivant l'une des revendications 113 à 125, caractérisé en ce que l'activation physique a lieu dans une chambre de traitement préalable séparée de la chambre de recouvrement (160).
